# EUROPEAN PATENT APPLICATION

(11) **EP 4 848 335 A1**
(43) Date of publication of application: **02.12.2026**
(21) Application number: 25744965.2
(22) Date of filing: 07.01.2025
(51) Int. Cl.: H01L 21/60, F21V 15/01, H01L 23/12, H01L 23/36, H05K 1/02, H10H 20/00, F21Y 115/10

(54) **SUPPORT, INCLINED MOUNTING MODULE, CIRCUIT MODULE, ELECTRONIC APPARATUS, AND METHOD FOR MANUFACTURING CIRCUIT MODULE**

(30) Priority: 25.01.2024 JP 2024009526; 29.05.2024 JP 2024087398
(71) Applicant: Panasonic Intellectual Property Management Co., Ltd., Kadoma-shi, Osaka 571-0057 (JP)
(72) Inventor: OISHI, Koki, Kadoma-shi, Osaka 571-0057 (JP); OSHIO, Shozo, Kadoma-shi, Osaka 571-0057 (JP); SATO, Toshihiko, Kadoma-shi, Osaka 571-0057 (JP); IIZAWA, Noboru, Kadoma-shi, Osaka 571-0057 (JP); MITSUOKA, Shun, Kadoma-shi, Osaka 571-0057 (JP)
(74) Representative: Müller-Boré & Partner Patentanwälte PartG mbB
(86) International application number: PCT/JP2025/000111
(87) International publication number: WO 2025/158882

(57) **Abstract**

A support (1) includes: a first mounting surface (1a); a second mounting surface (1b); and a first electrode (11) and a second electrode (12) each exposed on both the first mounting surface (1a) and the second mounting surface (1b). The first mounting surface (1a) is an inclined surface inclined relative to the second mounting surface (1b). A first electrode and a second electrode of an electronic component are connected to the first electrode (11) and the second electrode (12) of the support (1) via solder (3). The first electrode (11) and the second electrode (12) of the support (1) exposed on the first mounting surface (1a) include, respectively, a first electrode edge (11S) and a second electrode edge (12S) located on the lower side of the inclined surface. The first electrode edge (11S) and the second electrode edge (12S) serve as alignment references when the electronic component is mounted on the support (1) using solder (3), and are spaced from the second mounting surface (1b) in a direction orthogonal to the second mounting surface (1b).

## Description

### [Technical Field]

The present invention relates to an inclined mounting technique for mounting an electronic component at an angle and to applications thereof. Specifically, the present invention relates to, for example, a support for inclined mounting of an electronic component, an inclined mounting module including the support, a circuit module including the inclined mounting module, an electronic device including the support, and a method for manufacturing the circuit module.

### [Background Art]

Conventionally, inclined mounting techniques are known in which electronic components such as solid-state light-emitting elements or detection elements are mounted at an angle relative to a board (for example, Patent Literature (PTL) 1, 2, and 3).

When mounting electronic components on a board at an angle, it is conceivable to use a support having an inclined surface for inclined mounting. In this case, by mounting an electronic component on the inclined surface formed on the support, it is possible to obtain an inclined mounting module having a structure in which the electronic component is mounted on the support in an inclined orientation. Further, by mounting the inclined mounting module on a circuit board, it is possible to obtain a circuit module having a structure in which the electronic component mounted on the support is inclined relative to the circuit board. Note that surface-mount electronic components are predominant nowadays, and electrode materials containing copper as the main component are used for their mounting.

### [Citation List]

### [Patent Literature]

[PTL 1] Japanese Unexamined Patent Application Publication No. 2013-143319
[PTL 2] Japanese Patent No. 5007395
[PTL 3] WO2011/102335

### [Summary of Invention]

### [Technical Problem]

However, the structure of the conventional support for inclined mounting has a problem that the electronic component mounted on the support is displaced from its predetermined mounting position on the support. In particular, when attempting to mount a surface-mount electronic component, the electronic component is displaced from its predetermined mounting position.

The present invention has been made to address such a problem, and has an object to provide a support and the like that enable easy alignment of an electronic component without the electronic component being displaced from its predetermined mounting position on the support.

### [Solution to Problem]

In order to achieve the above object, a support according to an aspect of the present invention is a support to be mounted on a board while supporting an electronic component, the support including, at least: one or more first mounting surfaces on which a mounting surface of the electronic component is to be mounted; a second mounting surface via which the support is to be mounted on the board; a first electrode exposed on both the one or more first mounting surfaces and the second mounting surface; and a second electrode exposed on both the one or more first mounting surfaces and the second mounting surface. Each of the one or more first mounting surfaces is an inclined surface that is inclined relative to the second mounting surface. The first electrode and the second electrode are thermal conductors that conduct heat from the one or more first mounting surfaces to the second mounting surface. A first electrode of the electronic component is connected to the first electrode of the support via solder. A second electrode of the electronic component is connected to the second electrode of the support via solder. The first electrode of the support exposed on the one or more first mounting surfaces includes a first electrode edge located on a lower side of the inclined surface. The second electrode of the support exposed on the one or more first mounting surfaces includes a second electrode edge located on the lower side of the inclined surface. The first electrode edge and the second electrode edge serve as alignment references for aligning the electronic component when the electronic component is mounted on the support using solder, and are spaced apart from the second mounting surface in a direction orthogonal to the second mounting surface.

In addition, an inclined mounting module according to an aspect of the present invention includes: the support described above; and an electronic component mounted on the one or more first mounting surfaces of the support via solder.

In addition, a circuit module according to an aspect of the present invention includes: the inclined mounting module described above; and a circuit board on which the inclined mounting module is mounted. The inclined mounting module is mounted on the circuit board via the second mounting surface of the support.

In addition, an electronic device according to an aspect of the present invention includes: at least one of the inclined mounting module described above or the circuit module described above.

In addition, a method for manufacturing a circuit module according to an aspect of the present invention is a method for manufacturing the circuit module described above and includes: a first placing process of placing an electronic component on the one or more first mounting surfaces of the support via first solder; a second placing process of placing the support on an electrode of the circuit board via second solder; and a mounting process of mounting the electronic component on the support using the first solder and mounting the support on the circuit board using the second solder. The mounting process is performed after the first placing process and the second placing process.

In addition, a method for manufacturing a circuit module according to another aspect of the present invention is a method for manufacturing the circuit module described above and includes: a first mounting process of mounting an electronic component on the one or more first mounting surfaces of the support via solder; an inclining process of inclining the support on which the electronic component has been mounted, the inclining process being performed after the first mounting process; and a second mounting process of mounting, on an electrode of the circuit board, via solder, the support on which the electronic component has been mounted, the support being mounted via the second mounting surface, the second mounting process being performed after the inclining process. A first mounting direction in which the electronic component is mounted on the support in the first mounting process and a second mounting direction in which the support is mounted on the electrode of the circuit board in the second mounting process are the same direction.

### [Advantageous Effects of Invention]

The present invention can provide: a support that enables easy alignment of an electronic component without the electronic component being displaced from its predetermined mounting position on the support; an inclined mounting module that includes the support; a circuit module that includes the inclined mounting module; and an electronic device that includes the inclined mounting module or the circuit module.

The present invention can also provide a method for manufacturing a circuit module that enables easy alignment of an electronic component without the electronic component being displaced from its predetermined mounting position on a support.

### [Brief Description of Drawings]

[FIG. 1]

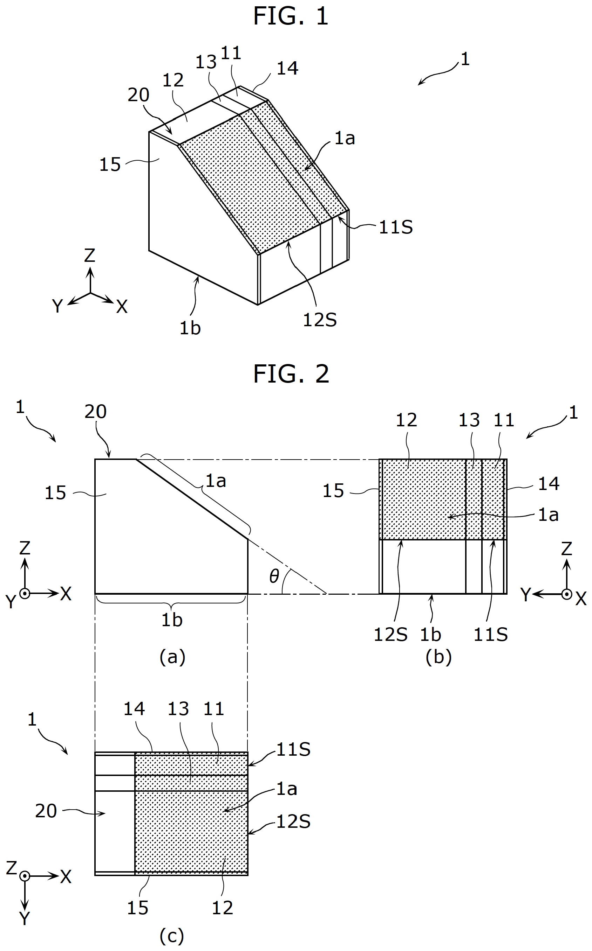

   FIG. 1 is a perspective view of a support according to Embodiment 1.
[FIG. 2]
   FIG. 2 is a diagram illustrating the configuration of a support according to Embodiment 1.
[FIG. 3]

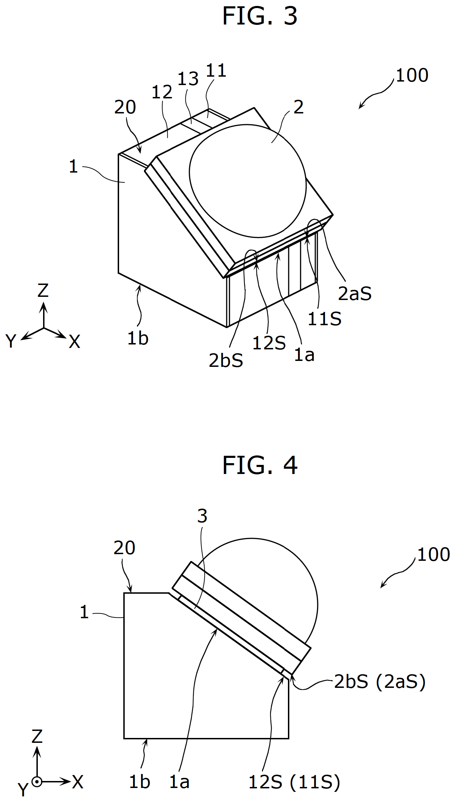

   FIG. 3 is a perspective view of an inclined mounting module according to Embodiment 1.
[FIG. 4]
   FIG. 4 is a side view of an inclined mounting module according to Embodiment 1.
[FIG. 5]

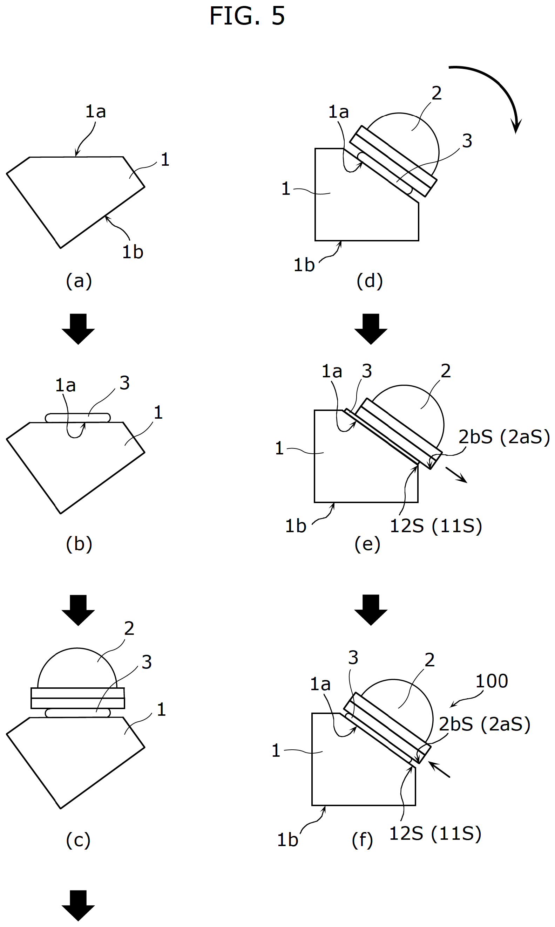

   FIG. 5 is a diagram for describing an example of a method for manufacturing an inclined mounting module according to Embodiment 1.
[FIG. 6]

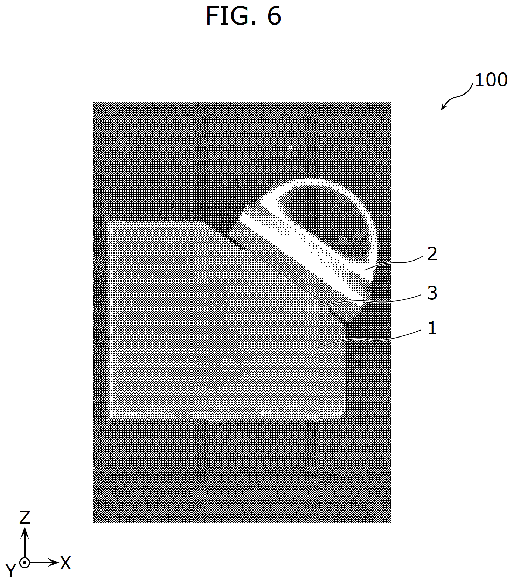

   FIG. 6 is an optical photograph showing a side view of an inclined mounting module according to Embodiment 1 that was actually fabricated.
[FIG. 7]

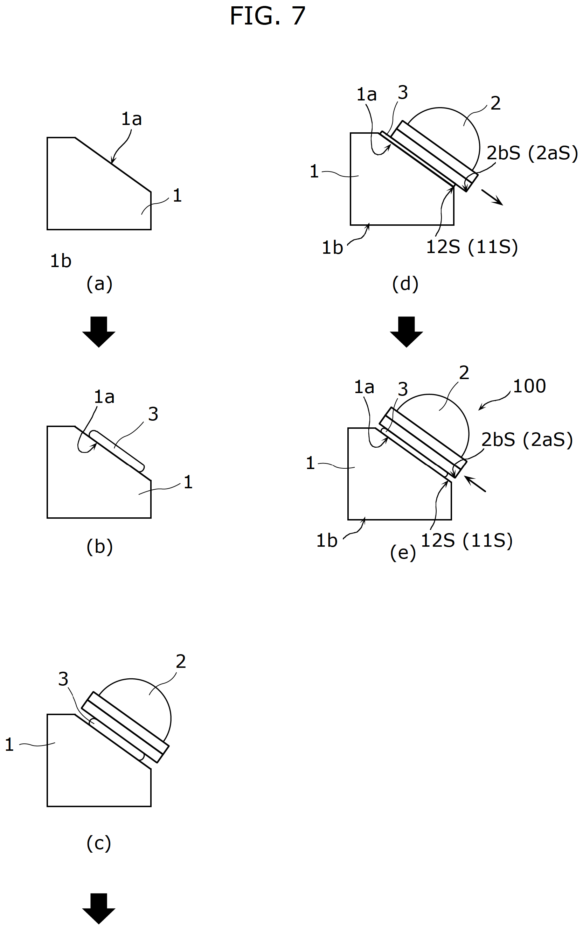

   FIG. 7 is a diagram for describing another example of a method for manufacturing an inclined mounting module according to Embodiment 1.
[FIG. 8]

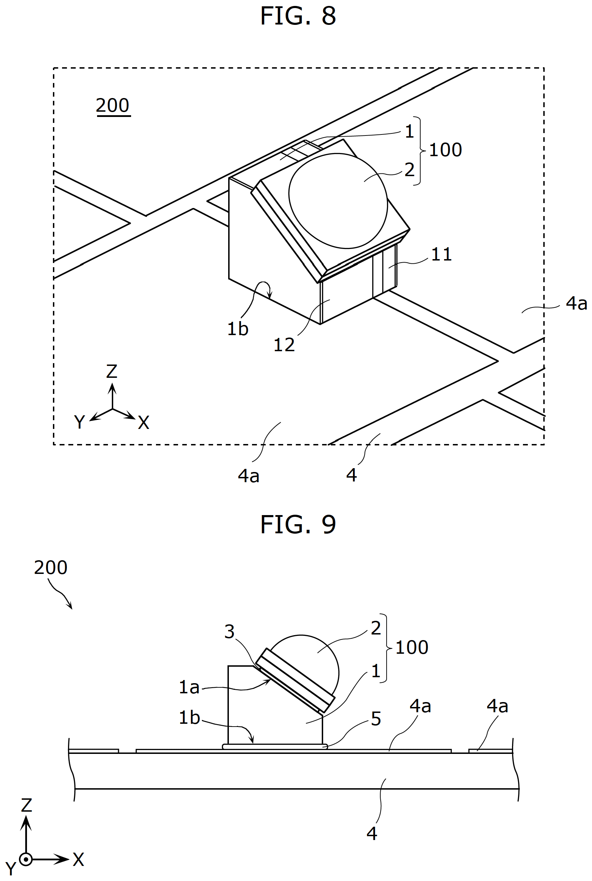

   FIG. 8 is a perspective view illustrating a portion of a circuit module according to Embodiment 1.
[FIG. 9]
   FIG. 9 is a side view illustrating a portion of a circuit module according to Embodiment 1.
[FIG. 10]

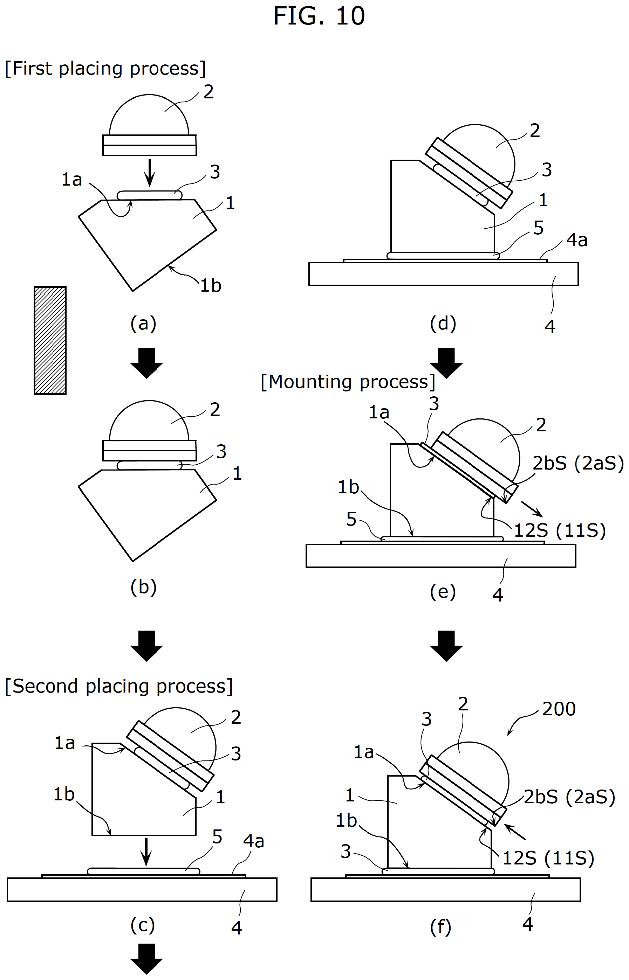

   FIG. 10 is a diagram for describing an example of a method for manufacturing a circuit module according to Embodiment 1.
[FIG. 11]

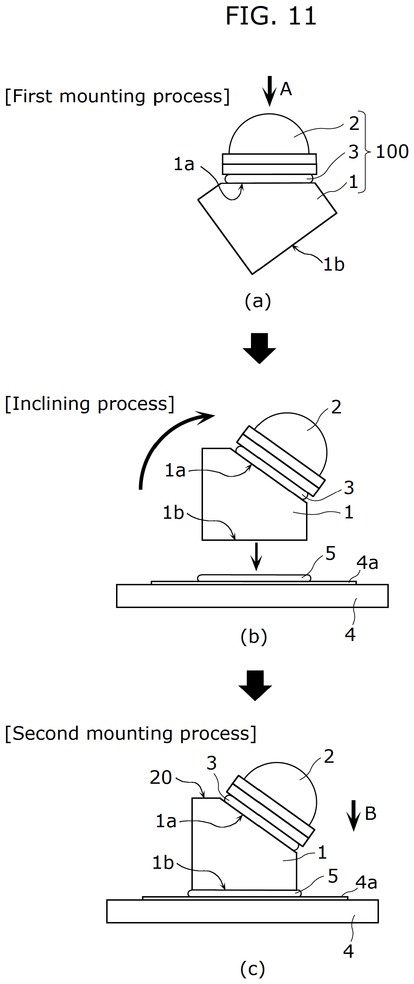

   FIG. 11 is a diagram for describing another example of a method for manufacturing a circuit module according to Embodiment 1.
[FIG. 12]

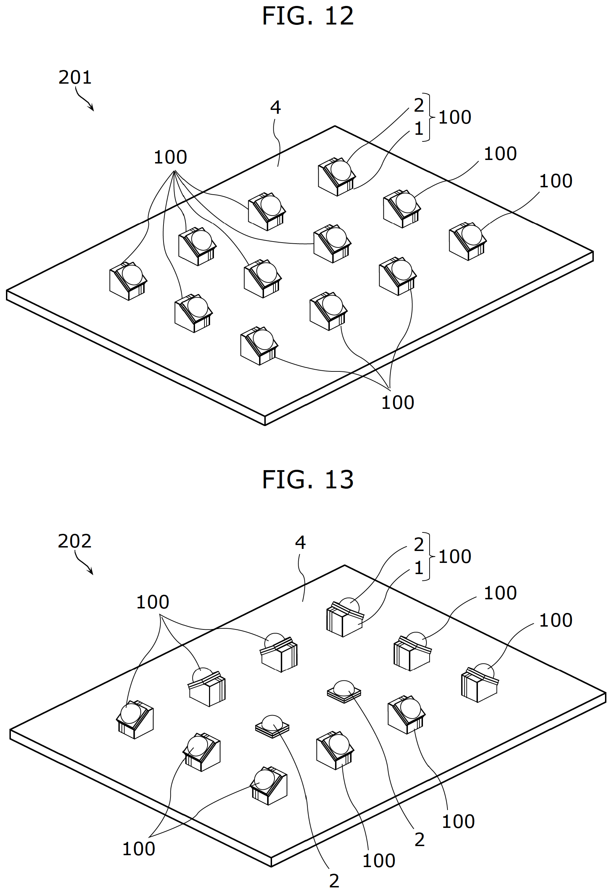

   FIG. 12 is a perspective view of a circuit module according to Variation 1 of Embodiment 1.
[FIG. 13]
   FIG. 13 is a perspective view of a circuit module according to Variation 2 of Embodiment 1.
[FIG. 14]

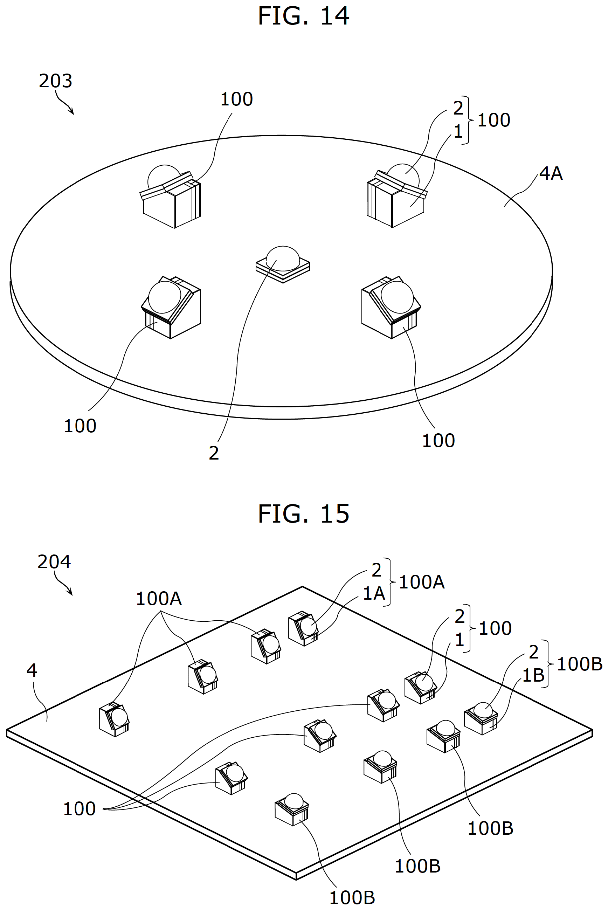

   FIG. 14 is a perspective view of a circuit module according to Variation 3 of Embodiment 1.
[FIG. 15]
   FIG. 15 is a perspective view of a circuit module according to Variation 4 of Embodiment 1.
[FIG. 16]

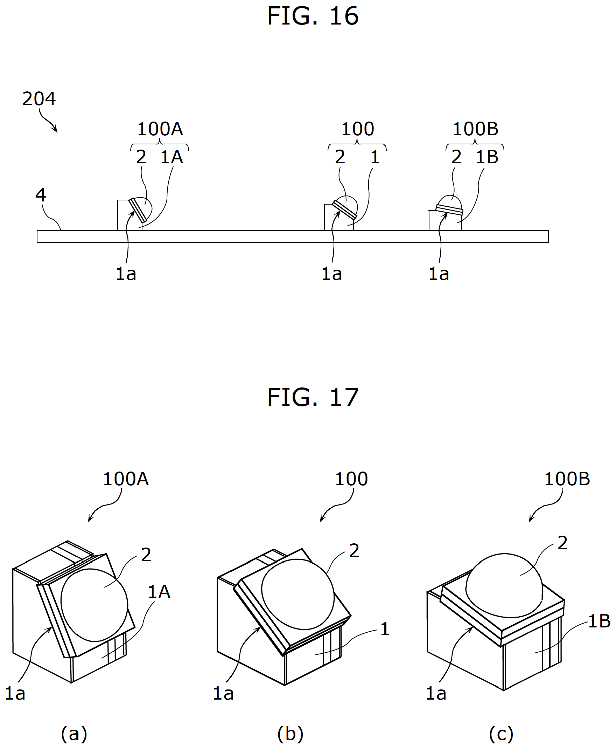

   FIG. 16 is a side view of a circuit module according to Variation 4 of Embodiment 1.
[FIG. 17]
   FIG. 17 is a perspective view of inclined mounting modules included in a circuit module according to Variation 4 of Embodiment 1.
[FIG. 18]

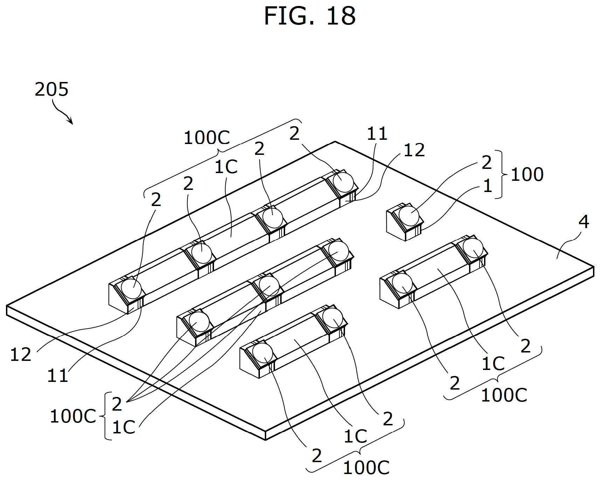

   FIG. 18 is a perspective view of a circuit module according to Variation 5 of Embodiment 1.
[FIG. 19]

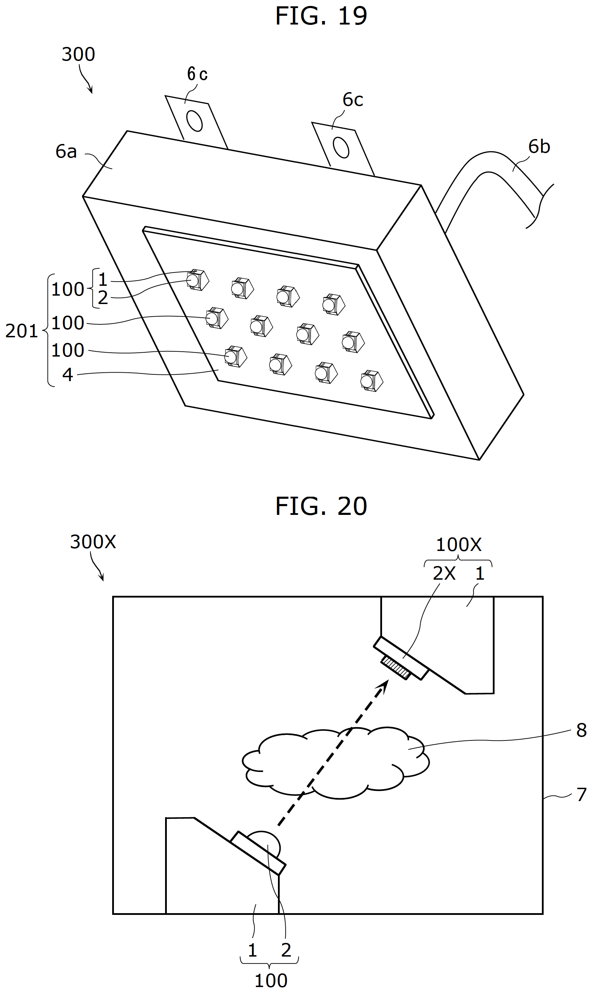

   FIG. 19 is a perspective view of an electronic device according to Embodiment 1.
[FIG. 20]
   FIG. 20 is a schematic view of an electronic device in another example according to Embodiment 1.
[FIG. 21]

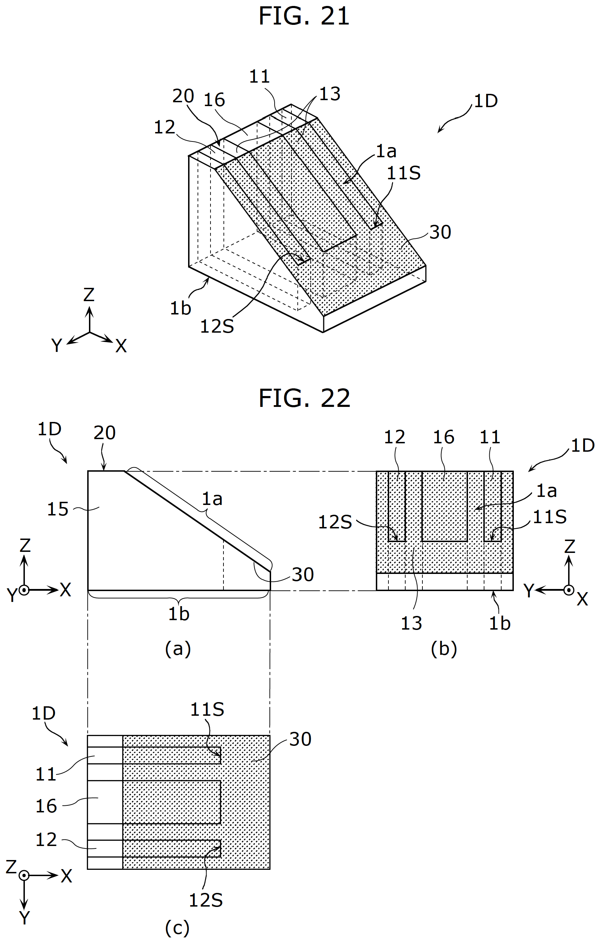

   FIG. 21 is a perspective view of a support according to Embodiment 2.
[FIG. 22]
   FIG. 22 is a diagram illustrating the configuration of a support according to Embodiment 2.
[FIG. 23]

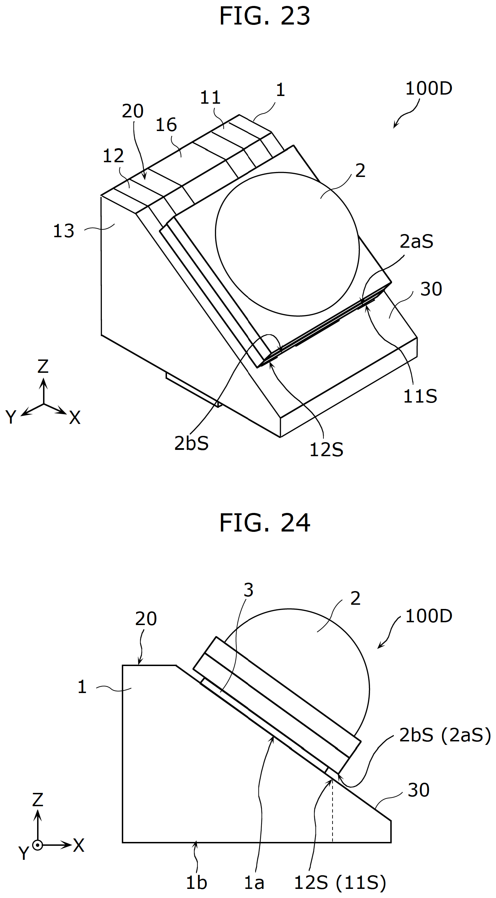

   FIG. 23 is a perspective view of an inclined mounting module according to Embodiment 2.
[FIG. 24]
   FIG. 24 is a side view of an inclined mounting module according to Embodiment 2.
[FIG. 25]

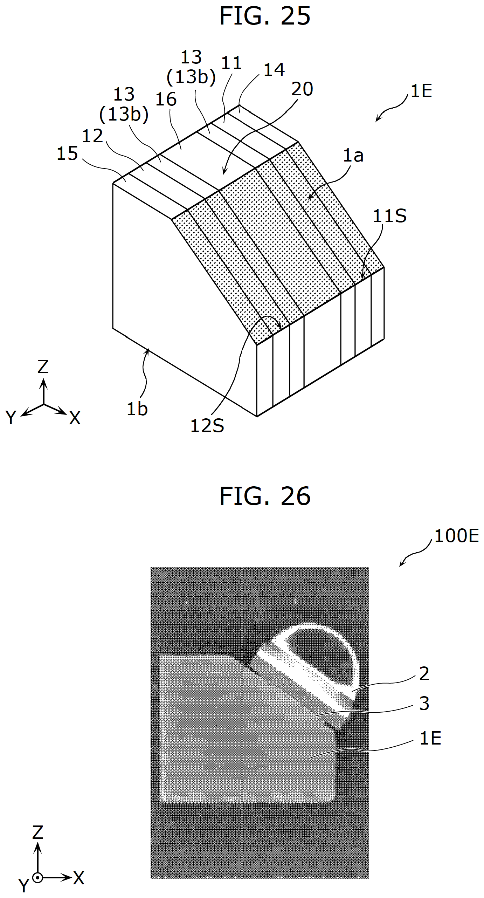

   FIG. 25 is a perspective view of a support according to Embodiment 3.
[FIG. 26]
   FIG. 26 is an optical photograph showing a side view of an inclined mounting module according to Embodiment 3 that was actually fabricated.
[FIG. 27]

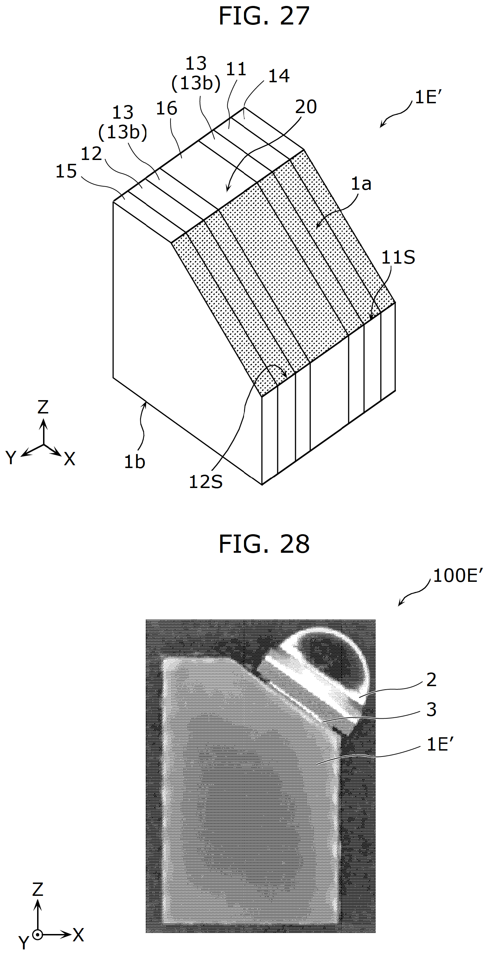

   FIG. 27 is a perspective view of a support according to a variation of Embodiment 3.
[FIG. 28]
   FIG. 28 is an optical photograph showing a side view of an inclined mounting module according to a variation of Embodiment 3 that was actually fabricated.
[FIG. 29]

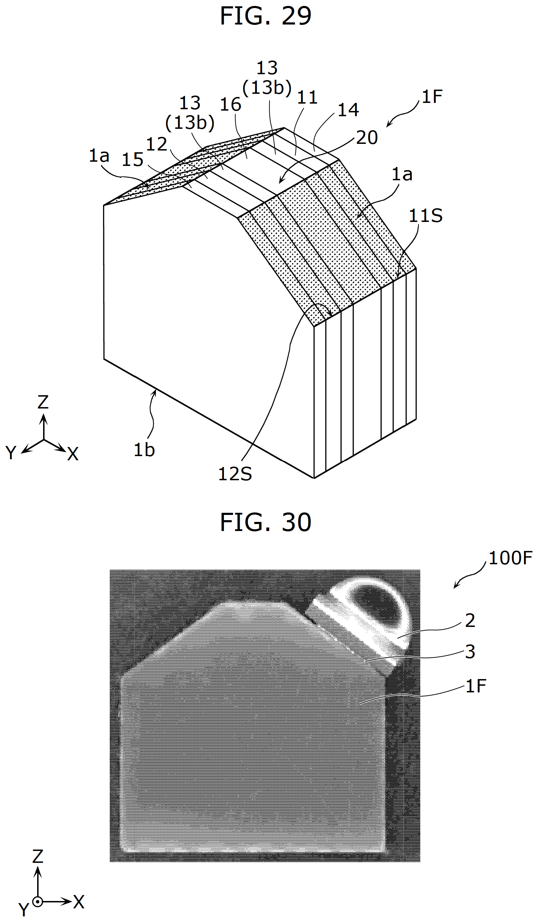

   FIG. 29 is a perspective view of a support according to Embodiment 4.
[FIG. 30]
   FIG. 30 is an optical photograph showing a side view of an inclined mounting module according to a variation of Embodiment 4 that was actually fabricated.
[FIG. 31]

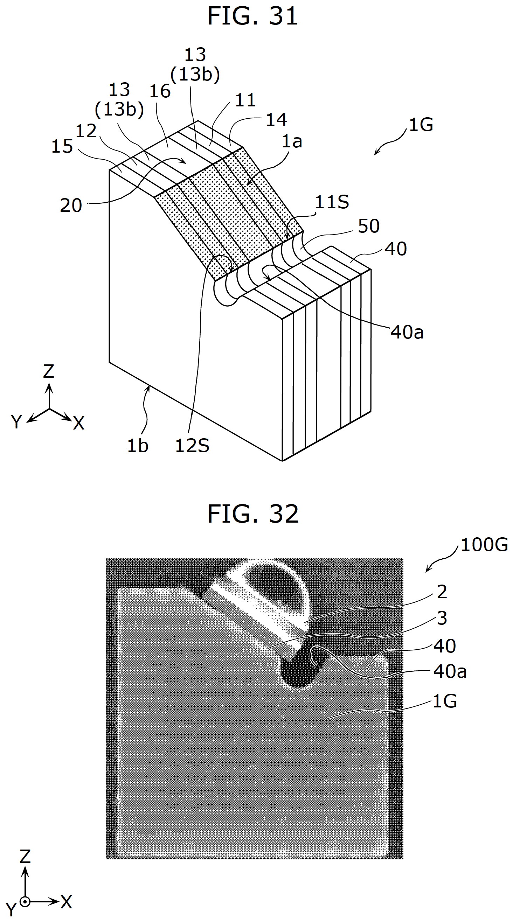

   FIG. 31 is a perspective view of a support according to Embodiment 5.
[FIG. 32]
   FIG. 32 is an optical photograph showing a side view of an inclined mounting module according to Embodiment 5 that was actually fabricated.
[FIG. 33]

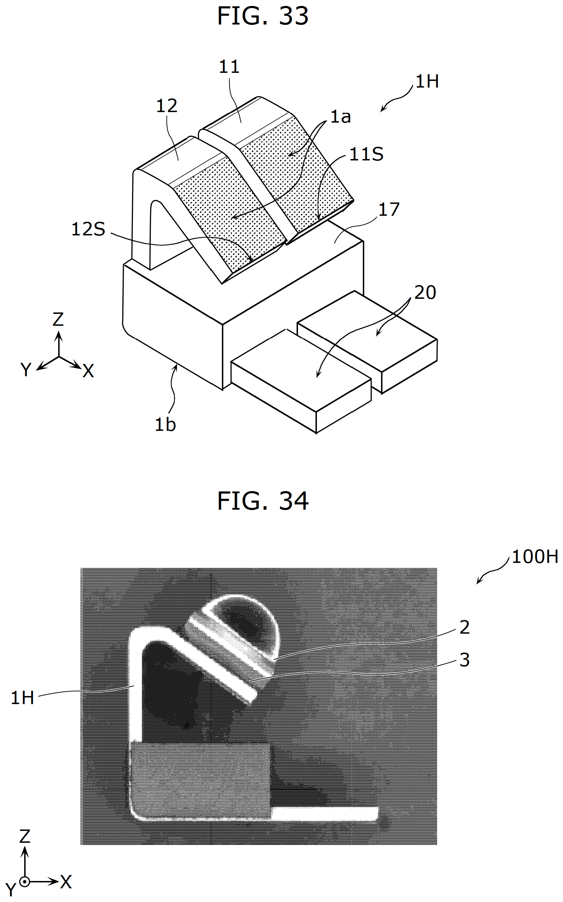

   FIG. 33 is a perspective view of a support according to Embodiment 6.
[FIG. 34]
   FIG. 34 is an optical photograph showing a side view of an inclined mounting module according to Embodiment 6 that was actually fabricated.
[FIG. 35]

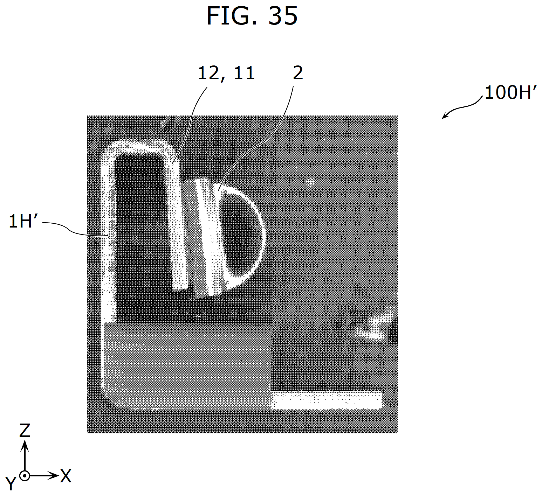

   FIG. 35 is an optical photograph showing a side view of an inclined mounting module according to a variation of Embodiment 6 that was actually fabricated.
[FIG. 36]

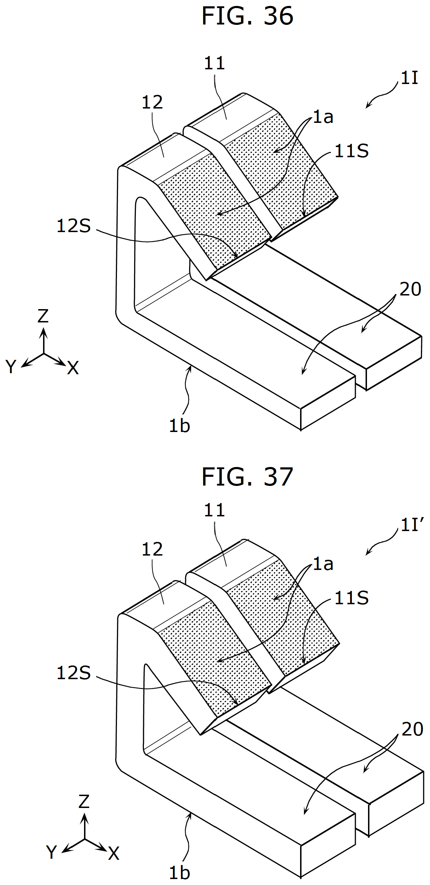

   FIG. 36 is a perspective view of a support according to Embodiment 7.
[FIG. 37]
   FIG. 37 is a perspective view of a support according to Variation 1 of Embodiment 7.
[FIG. 38]

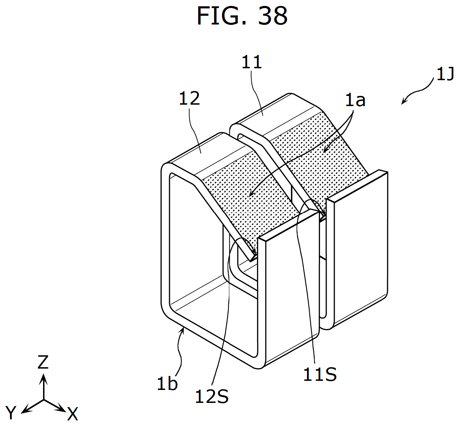

   FIG. 38 is a perspective view of a support according to Variation 2 of Embodiment 7.
[FIG. 39]

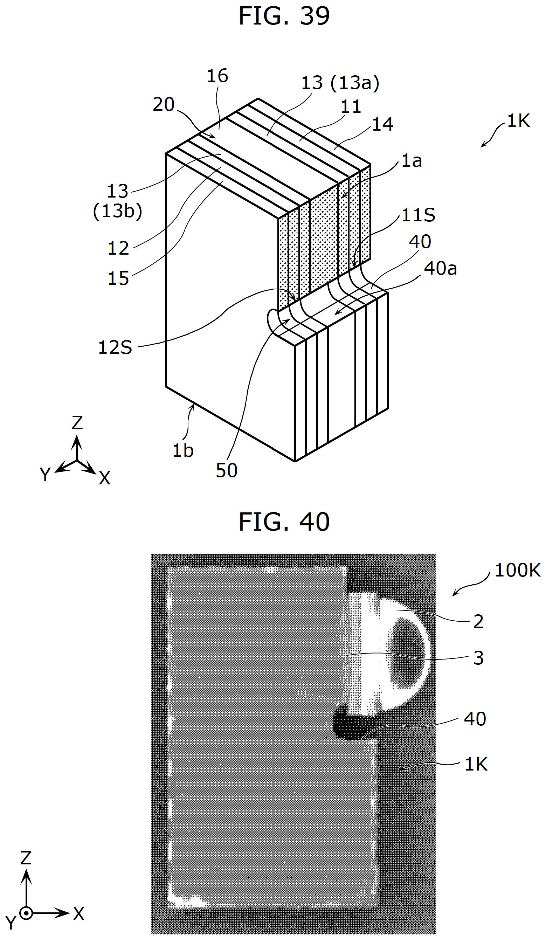

   FIG. 39 is a perspective view of a support according to Embodiment 8.
[FIG. 40]
   FIG. 40 is an optical photograph showing a side view of an inclined mounting module according to Embodiment 8.
[FIG. 41]

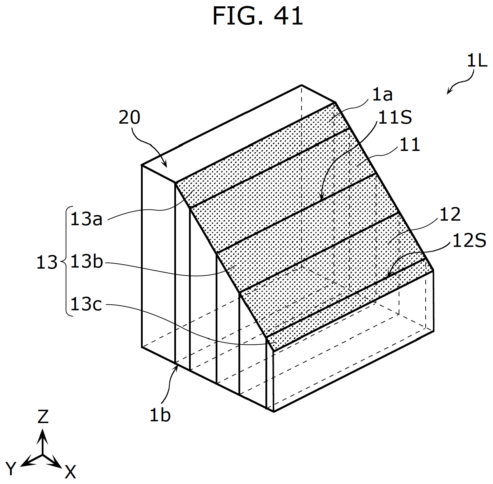

   FIG. 41 is a perspective view of a support according to Embodiment 9.
[FIG. 42]

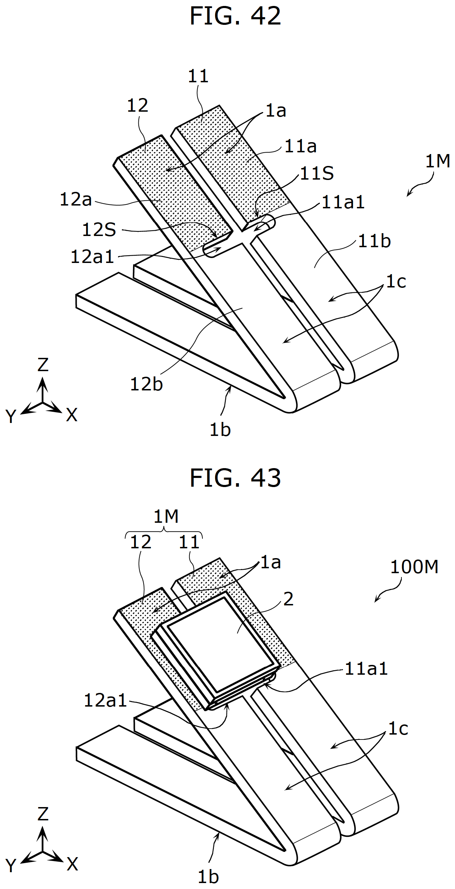

   FIG. 42 is a perspective view of a support according to Embodiment 10.
[FIG. 43]
   FIG. 43 is a perspective view of an inclined mounting module according to Embodiment 10.
[FIG. 44]

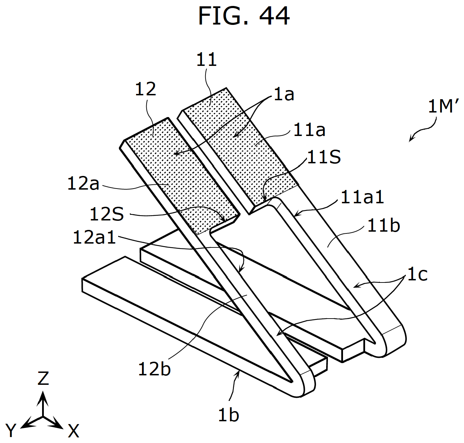

   FIG. 44 is a perspective view of a support according to Variation 1 of Embodiment 10.
[FIG. 45]

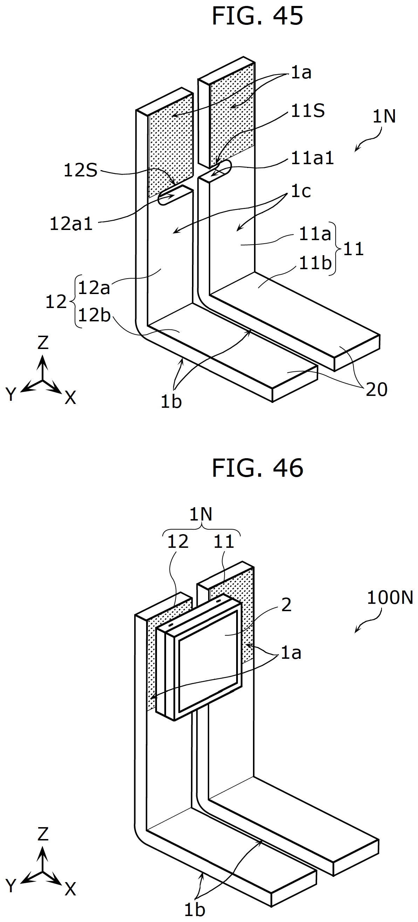

   FIG. 45 is a perspective view of a support according to Variation 2 of Embodiment 10.
[FIG. 46]
   FIG. 46 is a perspective view illustrating the configuration of a variation of an inclined mounting module according to Embodiment 10.
[FIG. 47]

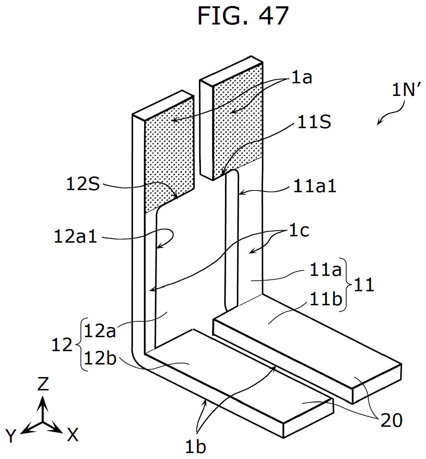

   FIG. 47 is a perspective view of a support according to Variation 3 of Embodiment 10.
[FIG. 48]

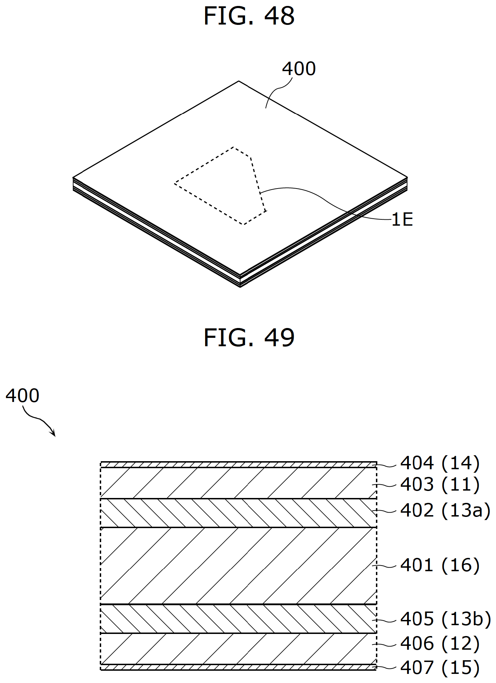

   FIG. 48 is a perspective view of a multilayer substrate used for fabricating a variation of a support according to Embodiment 3.
[FIG. 49]
   FIG. 49 is a cross-sectional view of a multilayer substrate used for fabricating a variation of a support according to Embodiment 3.
[FIG. 50]

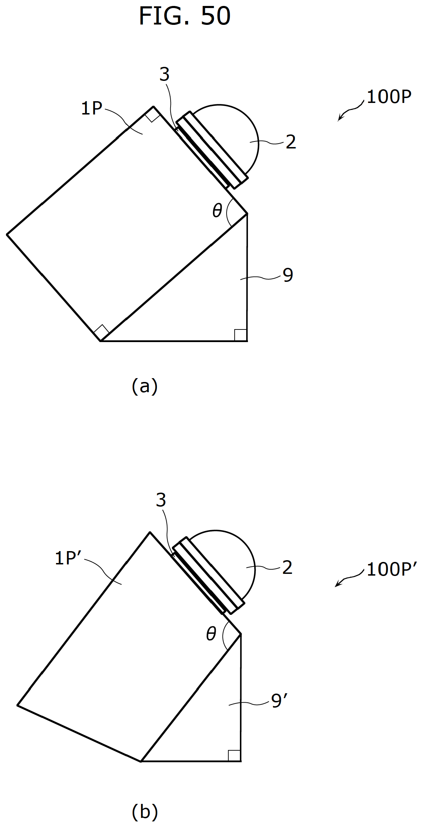

   FIG. 50 is a diagram illustrating the configurations of inclined mounting modules according to variations.
[FIG. 51]

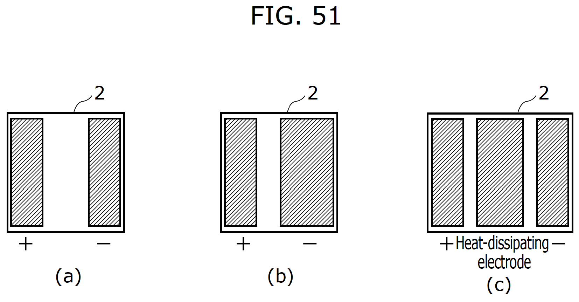

   FIG. 51 is a diagram illustrating electrode patterns of an electronic component.

### [Description of Embodiments]

### (Circumstances Leading to One Aspect of the Present Invention)

Prior to describing embodiments of the present invention, the circumstances that have led to one aspect of the present invention will be described.

In fabricating an inclined mounting module including a support for inclined mounting and an electronic component mounted on an inclined surface of the support, the inventors of the present application repeatedly conducted various experiments in view of the problem that, when attempting to fix the electronic component, the electronic component slides down the inclined surface of the support and is displaced from its predetermined position. In the course of such experiments, the inventors found that in some cases a phenomenon occurs in which the electronic component is automatically aligned without being displaced from its predetermined mounting position on the support. Specifically, the inventors found that, by leaving an electrode of the support exposed in a certain state on a mounting surface (inclined surface) of the support on which the electronic component is to be mounted, when solder is applied to the electrode of the support and the electronic component is placed on the solder and then reflow is performed, molten solder exhibits an action to reduce its volume as much as possible. The inventors found that, as a result of this action, the electrode exposed on the mounting surface of the support and the electrode of the electronic component are automatically aligned. Taking advantage of this phenomenon, the inventors extensively studied various structures of the support, as well as various methods for manufacturing the inclined mounting module, and arrived at one aspect of the present invention.

Hereinafter, specific embodiments of the present invention will be described with reference to the drawings. Each of the embodiments described below shows a specific example of the present invention. Therefore, the numerical values, shapes, materials, constituent elements, the arrangement and connection of the constituent elements, steps (processes), the processing order of the steps, etc. shown in the following embodiments are mere examples, and are not intended to limit the present invention. Thus, among the constituent elements in the following embodiments, those not recited in any of the independent claims representing the most generic concepts of the present invention will be described as optional constituent elements.

Note that the drawings are represented schematically and are not necessarily precise illustrations. Additionally, constituent elements that are substantially the same are given the same reference signs in the drawings, and redundant descriptions will be omitted or simplified. In each drawing, X-axis, Y-axis, and Z-axis represent the three axes of a three-dimensional Cartesian coordinate system, and in the present embodiment, the Z-axis direction is the vertical direction, and the direction perpendicular to the Z-axis (the direction parallel to the XY plane) is the horizontal direction. The X-axis and Y-axis are orthogonal to each other and are each orthogonal to the Z-axis. Note that in the present specification, the terms "upper", "up", "upward" "lower", and "down" do not necessarily refer to the absolute upward and downward directions (vertically up and vertically down) in space recognition.

### [Embodiment 1]

First, the configuration of support 1 according to Embodiment 1 will be described with reference to FIG. 1 and FIG. 2. FIG. 1 is a perspective view of support 1 according to Embodiment 1. FIG. 2 is a diagram illustrating the configuration of support 1 according to Embodiment 1. In FIG. 2, (a) is a side view of support 1, (b) is a front view of support 1, and (c) is a top view of support 1.

Support 1 is a support member that supports an electronic component (not illustrated) mounted thereon. Support 1 that supports the electronic component is mounted on, for example, a board (not illustrated) such as a circuit board. Therefore, as illustrated in FIG. 1 and FIG. 2, support 1 includes at least first mounting surface 1a, which is the surface on which the mounting surface of the electronic component is to be mounted, and second mounting surface 1b, which is the surface via which support 1 is to be mounted on the board. First mounting surface 1a is a support surface that supports the electronic component.

First mounting surface 1a and second mounting surface 1b are exposed surfaces of electrodes of support 1. Specifically, first mounting surface 1a is the surface (upper surface) on the upper side of support 1, and second mounting surface 1b is the surface (lower surface) on the lower side of support 1. First mounting surface 1a and second mounting surface 1b are each a flat plane (for example, surface irregularities are ±0.25 mm or less).

First mounting surface 1a is an inclined surface that is inclined relative to second mounting surface 1b. Specifically, first mounting surface 1a is inclined at inclination angle θ of at least 5 degrees and at most 85 degrees relative to second mounting surface 1b (see FIG. 2). Therefore, first mounting surface 1a and second mounting surface 1b are not parallel to each other. Inclination angle θ of first mounting surface 1a is preferably at least 10 degrees and at most 60 degrees, more preferably at least 20 degrees and at most 50 degrees, and further preferably at most 45 degrees. Note that, in the present embodiment, first mounting surface 1a is the entirety of the inclined surface formed on support 1. That is, first mounting surface 1a is the region indicated by dotted hatching in FIG. 1 and FIG. 2. As illustrated in (b) of FIG. 2, when entire first mounting surface 1a is viewed from a direction parallel to second mounting surface 1b, support 1 has a configuration in which the maximum width of the upper half of first mounting surface 1a is equal to the maximum width of the lower half of first mounting surface 1a. Specifically, the width of first mounting surface 1a (inclined surface) is uniform from the upper end to the lower end. In the present embodiment, second mounting surface 1b is the entirety of the lower surface of support 1. The width of second mounting surface 1b is also uniform from one end portion to the other end portion.

Note that first mounting surface 1a may be a portion of the inclined surface of support 1, and second mounting surface 1b may be a portion of the lower surface of support 1. In the present embodiment, first mounting surface 1a is a single surface, but the present disclosure is not limited thereto. For example, first mounting surface 1a may be divided into a plurality of surfaces. Likewise, second mounting surface 1b may also be divided into a plurality of surfaces. That is, each of first mounting surface 1a and second mounting surface 1b may include a plurality of separate surfaces.

As illustrated in FIG. 1 and FIG. 2, support 1 includes first electrode 11, second electrode 12, and insulator 13. Support 1 further includes first protector 14 and second protector 15. Each of first electrode 11, second electrode 12, insulator 13, first protector 14, and second protector 15 is bonded to an adjacent member.

First electrode 11 and second electrode 12 are electrical conductors for supplying electric power to the electronic component mounted on first mounting surface 1a. That is, a first electrode of the electronic component is connected to first electrode 11 via solder, and a second electrode of the electronic component is connected to second electrode 12 via solder. For example, one of first electrode 11 or second electrode 12 of support 1 is a positive electrode, and the other is a negative electrode. Note that, when the electronic component mounted on support 1 is driven by an AC voltage instead of a DC voltage, first electrode 11 and second electrode 12 need not be distinguished as a positive electrode and a negative electrode.

Each of first electrode 11 and second electrode 12 is exposed on first mounting surface 1a. Each of first electrode 11 and second electrode 12 is also exposed on second mounting surface 1b. Therefore, electric power can be supplied from second mounting surface 1b to the electronic component mounted on first mounting surface 1a. Specifically, by mounting support 1 on a circuit board via second mounting surface 1b, electric power can be supplied to the pair of the first electrode and the second electrode (positive electrode and negative electrode) of the electronic component mounted on first mounting surface 1a via the pair of first electrode 11 and second electrode 12. That is, first electrode 11 and second electrode 12 function as electrical conductors.

First electrode 11 and second electrode 12 not only function as electrical conductors but also function as thermal conductors that conduct heat. Specifically, first electrode 11 and second electrode 12 conduct heat from first mounting surface 1a to second mounting surface 1b. In the present embodiment, first electrode 11 and second electrode 12 function as principal thermal conductors of support 1. That is, although support 1 includes some heat-conductive members that conduct heat from first mounting surface 1a to second mounting surface 1b, first electrode 11 and second electrode 12 conduct the greatest amount of heat from first mounting surface 1a to second mounting surface 1b among those heat-conductive members. Therefore, heat generated by the electronic component mounted on first mounting surface 1a is conducted from first mounting surface 1a to second mounting surface 1b via first electrode 11 and second electrode 12 and dissipated.

In the present embodiment, since first electrode 11 and second electrode 12 are exposed on each of first mounting surface 1a and second mounting surface 1b, the envelope volume of each of first electrode 11 and second electrode 12 can be increased. Thus, first electrode 11 and second electrode 12 serve as favorable heat-conductive members, enabling heat generated by the electronic component mounted on first mounting surface 1a to be efficiently conducted to second mounting surface 1b via first electrode 11 and second electrode 12.

The electrode material used for first electrode 11 and second electrode 12 is a material having electrical conductivity. The electrode material used for first electrode 11 and second electrode 12 is not particularly limited so long as it has electrical conductivity; however, from the viewpoints of workability and thermal conduction, the electrode material contains metal, for example. In the present embodiment, first electrode 11 and second electrode 12 are made of a metal material. As an example, first electrode 11 and second electrode 12 are at least one selected from, for instance, aluminum, gold, silver, copper, or an alloy containing any of these. These metal materials are metals having a thermal conductivity exceeding 200 W/m·K at room temperature. In particular, since the thermal conductivities of gold, silver, and copper exceed 300 W/m·K, forming first electrode 11 and second electrode 12 of gold, silver, or copper yields support 1 having excellent thermal conductivity from first mounting surface 1a to second mounting surface 1b. Also, taking manufacturing cost into consideration, first electrode 11 and second electrode 12 may be copper electrodes containing copper as the main component. In this case, first electrode 11 and second electrode 12 may be made of a metal material (for example, brass, bronze, copper) containing at least 30 wt% copper, preferably at least 40 wt% copper.

In the present embodiment, first electrode 11 and second electrode 12 are plate-shaped metal blocks, and end surfaces of the metal blocks form part of first mounting surface 1a and second mounting surface 1b. Thus, some of the surfaces of first electrode 11 and second electrode 12 form part of first mounting surface 1a and second mounting surface 1b. Specifically, first electrode 11 and second electrode 12 are flat plate-shaped metal blocks each having a constant thickness. First electrode 11 and second electrode 12 are disposed parallel to each other.

Note that the volume fraction of metal in support 1 (for example, the volume fraction of first electrode 11 and second electrode 12 in support 1) is at least 30%, for example, preferably greater than 50%, for example. Accordingly, support 1 having excellent thermal conductivity from first mounting surface 1a to second mounting surface 1b can be obtained.

At least on first mounting surface 1a, each of first electrode 11 and second electrode 12 extends in the inclination direction of first mounting surface 1a. That is, the portions of first electrode 11 and second electrode 12 exposed on first mounting surface 1a extend in the inclination direction of first mounting surface 1a. Note that each of first electrode 11 and second electrode 12 extends also on second mounting surface 1b. Specifically, on second mounting surface 1b, each of first electrode 11 and second electrode 12 extends in the X-axis direction.

First electrode 11 and second electrode 12 have different electrode widths on first mounting surface 1a and second mounting surface 1b. Specifically, the electrode width of second electrode 12 is greater than the electrode width of first electrode 11 on each of first mounting surface 1a and second mounting surface 1b. Note that the electrode width of first electrode 11 and the electrode width of second electrode 12 may be the same.

Insulator 13 is located between first electrode 11 and second electrode 12. That is, support 1 has a layered structure in which first electrode 11, insulator 13, and second electrode 12 are stacked. Insulator 13 is an electrically insulating member for electrically insulating first electrode 11 and second electrode 12 from each other, and is made of an electrically insulating material having an electrically insulating property. Examples of the electrically insulating material forming insulator 13 include electrically insulating resin and ceramics.

Insulator 13 is exposed on each of first mounting surface 1a and second mounting surface 1b. In the present embodiment, insulator 13 is a plate-shaped, electrically insulating member, and end surfaces of insulator 13 form part of first mounting surface 1a and second mounting surface 1b. Thus, some of the surfaces of insulator 13 form part of first mounting surface 1a and second mounting surface 1b. Specifically, insulator 13 is a flat plate-shaped, electrically insulating member having a constant thickness.

Plate-shaped insulator 13 is sandwiched between first electrode 11 and second electrode 12. Accordingly, one side surface of insulator 13 contacts a side surface of first electrode 11, and the other side surface of insulator 13 contacts a side surface of second electrode 12. Therefore, first electrode 11 and second electrode 12 are separated from each other by the width of insulator 13. Note that insulator 13 need not be a tangible object, and may merely be a void (an air layer). That is, first electrode 11 and second electrode 12 may be insulated and separated from each other by a void.

First protector 14 covers the side surface of first electrode 11 opposite to the side surface of first electrode 11 facing insulator 13. Second protector 15 covers the side surface of second electrode 12 opposite to the side surface of second electrode 12 facing insulator 13. First protector 14 and second protector 15 constitute part of the outer peripheral portion of support 1.

In the present embodiment, first protector 14 and second protector 15 are protective films or protective plates that are smaller than first electrode 11 and second electrode 12 in thickness. First protector 14 and second protector 15 are made of, for example, a metal material or a resin material. That is, first protector 14 and second protector 15 are metal films or resin films, or metal plates or resin plates. Note that first protector 14 and second protector 15 may be made of materials other than metal materials or resin materials. First protector 14 and second protector 15 may be made of an electrically conductive material having electrical conductivity such as a metal material, but may be made of an electrically insulating material having an electrically insulating property, such as an electrically insulating resin material. Accordingly, the outer peripheral portion of support 1 can be an insulating portion rather than a charging portion. Note that support 1 need not include first protector 14 and second protector 15. That is, the respective side surfaces of first electrode 11 and second electrode 12 may be exposed.

Although not illustrated, support 1 may include a fixing body for the purpose of ensuring mechanical strength of support 1 against vibration. Further, support 1 may include a heat-dissipating body for dissipating heat generated by the electronic component. In this case, the fixing body may also serve as the heat-dissipating body, or the heat-dissipating body may also serve as the fixing body. Also, first electrode 11 may also serve as the fixing body and/or the heat-dissipating body. Second electrode 12 may also serve as the fixing body and/or the heat-dissipating body.

On first mounting surface 1a of support 1 configured as described above, the electronic component is mounted using solder. That is, first mounting surface 1a is a solder region where solder is formed when mounting the electronic component. In this case, in the present embodiment, although first electrode 11, second electrode 12, and insulator 13 are exposed on first mounting surface 1a, solder is not formed on insulator 13; therefore, of first mounting surface 1a, first electrode 11 and second electrode 12 exposed on first mounting surface 1a constitute the solder region.

Note that second mounting surface 1b is a solder region where solder is formed when support 1 is mounted on a circuit board or the like using solder. Specifically, of second mounting surface 1b, first electrode 11 and second electrode 12 exposed on second mounting surface 1b constitute the solder region.

In support 1, first electrode 11 exposed on first mounting surface 1a includes first electrode edge 11S on the lower side of the inclined surface (the thinner side of support 1), and second electrode 12 exposed on first mounting surface 1a includes second electrode edge 12S on the lower side of the inclined surface (the thinner side of support 1). First electrode edge 11S and second electrode edge 12S serve as alignment references for aligning the electronic component when the electronic component is mounted on support 1 using solder. Thus, electrode edges of electrodes of the electronic component on the lower side of the inclined surface are located at first electrode edge 11S and second electrode edge 12S.

Specifically, first electrode edge 11S of first electrode 11 is an alignment reference for aligning the first electrode of the electronic component, and a first electrode edge of the first electrode of the electronic component on the lower side of the inclined surface is located at first electrode edge 11S. Likewise, second electrode edge 12S of second electrode 12 is an alignment reference for aligning the second electrode of the electronic component, and a second electrode edge of the second electrode of the electronic component on the lower side of the inclined surface is located at second electrode edge 12S.

First electrode edge 11S is an edge part of first electrode 11, and second electrode edge 12S is an edge part of second electrode 12. In the present embodiment, first electrode edge 11S is an electrode end that is an end portion of first electrode 11, and second electrode edge 12S is an electrode end that is an end portion of second electrode 12. Further, in the present embodiment, first electrode edge 11S and second electrode edge 12S are part of an edge of support 1. Specifically, first electrode edge 11S and second electrode edge 12S are part of an edge of first mounting surface 1a located on the lower side of first mounting surface 1a that is inclined (that is, the lower end of the inclined surface).

First electrode edge 11S and second electrode edge 12S are spaced apart from second mounting surface 1b in the direction orthogonal to second mounting surface 1b (the Z-axis direction). In other words, first electrode edge 11S and second electrode edge 12S are separated from second mounting surface 1b by a certain distance.

Thus, in support 1, first electrode edge 11S of first electrode 11 and second electrode edge 12S of second electrode 12 serve as alignment references for aligning the electronic component when the electronic component is mounted on support 1, and first electrode edge 11S and second electrode edge 12S are separated from second mounting surface 1b by a certain distance. Accordingly, when mounting the electronic component on support 1 using solder, the electronic component placed on solder applied to first electrode 11 and second electrode 12 is automatically aligned. That is, the electronic component can be readily aligned without being displaced from its predetermined mounting position on support 1. Note that the details of the alignment behavior of the electronic component will be described later.

Support 1 includes suction portion 20 to which a suction nozzle is to be attached by suction when support 1 is mounted on a board. Suction portion 20 is a plane that is located on the back side of second mounting surface 1b and is parallel to second mounting surface 1b. Therefore, the plane serving as suction portion 20 is inclined relative to first mounting surface 1a. In the present embodiment, the plane serving as suction portion 20 is formed continuously with first mounting surface 1a. Specifically, suction portion 20 is constituted by exposed surfaces of first electrode 11, second electrode 12, and insulator 13.

By providing suction portion 20 to support 1 as described above, support 1 can be readily attached and detached in a direction perpendicular to second mounting surface 1b using, for example, a mounting machine that includes a suction nozzle. As a result, support 1 can be handled and readily placed on a board using a mounting machine for industrial production. Specifically, a suction nozzle is attached to suction portion 20 of support 1 by suction to operate support 1 in the up-down direction and place support 1 on a board that is disposed to be parallel to the horizontal plane extending in the direction perpendicular to the gravity direction, thereby enabling easy mounting of support 1 on the board.

Note that, in the present embodiment, suction portion 20 is provided on the top surface of support 1; however, the position of suction portion 20 in support 1 is not particularly limited. For example, suction portion 20 may be provided at the bottom portion of support 1 or at an intermediate position in the height direction.

The envelope volume of support 1 configured as described above is, for example, at least 25 mm³ (0.025 cm³) and at most 30 cm³, preferably at least 30 mm³ (0.030 cm³) and at most 8000 mm³ (8 cm³), and particularly preferably at least 30 mm³ (0.030 cm³) and at most 1000 mm³ (1 cm³). By imparting such an envelope volume to support 1, support 1 becomes suitable for the mounting of an electronic component, such as a light-emitting diode (LED), at an angle on first mounting surface 1a that is inclined. As a result, not only can the electronic component be aligned to its predetermined mounting position, but also support 1 that exhibits excellent heat dissipation for heat generated by the electronic component can be obtained.

Next, inclined mounting module 100 including support 1 configured as described above will be described with reference to FIG. 3 and FIG. 4. FIG. 3 is a perspective view of inclined mounting module 100 according to Embodiment 1. FIG. 4 is a side view of inclined mounting module 100 according to Embodiment 1.

As illustrated in FIG. 3 and FIG. 4, inclined mounting module 100 includes support 1 and electronic component 2 mounted on first mounting surface 1a of support 1. Electronic component 2 is mounted on first mounting surface 1a of support 1 via solder 3. That is, solder 3 is interposed between support 1 and electronic component 2. Solder 3 is a bonding material that bonds electrodes (not illustrated) of electronic component 2 to first electrode 11 and second electrode 12 that are exposed on first mounting surface 1a of support 1.

Although not illustrated, electronic component 2 includes a first electrode and a second electrode. The first electrode of electronic component 2 includes first electrode edge 2aS located on the lower side of first mounting surface 1a that is inclined. The second electrode of electronic component 2 includes second electrode edge 2bS located on the lower side of first mounting surface 1a that is inclined.

Electronic component 2 is, for example, a solid-state light-emitting element such as an LED or a semiconductor laser. When electronic component 2 is a solid-state light-emitting element, the light output surface of the solid-state light-emitting element faces the same direction as the direction perpendicular to first mounting surface 1a. This facilitates optical design for light to be emitted from the solid-state light-emitting element when inclined mounting module 100 is mounted on a circuit board.

In the present embodiment, electronic component 2 is an LED. Specifically, electronic component 2 is a surface-mount-device (SMD) type LED element that is individually packaged. For example, a white LED package (package size: 3.5 mm × 3.5 mm × 2.35 mm) can be used as electronic component 2.

When electronic component 2 is a solid-state light-emitting element, the type of light emitted by the solid-state light-emitting element is not particularly limited. For example, a solid-state light-emitting element that emits one electromagnetic wave selected from ultraviolet, visible light, and infrared can be used as electronic component 2.

Here, at least one selected from UV-A (315 nm to 400 nm), UV-B (280 nm to 315 nm), and UV-C (100 nm to 280 nm) can be used as ultraviolet.

Also, at least one selected from, for example, violet light (380 nm to 430 nm), blue light (430 nm to 490 nm), green light (490 nm to 550 nm), yellow light (550 nm to 590 nm), orange light (590 nm to 640 nm), red light (640 nm to 780 nm), and white light can be used as visible light.

In this case, at least one selected from, for example, warm white (correlated color temperature: 2600 K to 3250 K), warm neutral white (3250 K to 3800 K), neutral white (3800 K to 4500 K), cool white (4600 K to 5500 K), and daylight (5700 K to 7100 K) can be used as white light.

Also, at least one selected from IR-A (0.78 µm to 1.4 µm), IR-B (1.4 µm to 3 µm), and IR-C (3 µm to 1000 µm) can be used as infrared.

Note that electronic component 2 need not have an active characteristic such as outputting light like a solid-state light-emitting element etc., and may have a passive characteristic to receive physical properties. For example, electronic component 2 may be a detection element (sensor), such as a semiconductor detection element, that receives physical properties such as light, sound, temperature, pressure, or odor. As the detection element, it is possible to use, for example, a light detection element that detects light, a sound detection element that detects sound, a temperature detection element that detects temperature, a pressure detection element that detects pressure, and an odor detection element that detects odor.

When electronic component 2 is a detection element, the detection surface of the detection element may face the same direction as the direction perpendicular to first mounting surface 1a. This facilitates optical design for light to be detected by the detection element when inclined mounting module 100 is mounted on a circuit board.

As the light detection element, it is possible to use, for example, a photodiode, a charge coupled device (CCD), or a complementary metal-oxide-semiconductor (CMOS) image sensor. As the sound detection element, it is possible to use a piezoelectric element or a condenser microphone, for example. As the temperature detection element, it is possible to use a thermoelectric element or a thermistor, for example. As the pressure detection element, it is possible to use a semiconductor pressure sensor, for example. As the odor detection element, it is possible to use a semiconductor gas sensor, for example. Note that the types of detection targets detected by the detection element are not limited to light, sound, temperature, pressure, odor, and the like.

Electronic component 2 may be other than a solid-state light-emitting device or a detection element. In any case, electronic component 2 may be of the SMD type. This eliminates the need for separate processing to mount electronic component 2 on first mounting surface 1a of support 1, and electronic component 2 can be mounted on support 1 merely by placing electronic component 2 on first mounting surface 1a via a bonding material such as solder. Thus, inclined mounting module 100 having excellent industrial producibility can be obtained.

When mounting electronic component 2 on support 1, electronic component 2 can be mounted on first mounting surface 1a of support 1 by a mounting technique using solder. Thus, as illustrated in FIG. 3 and FIG. 4, solder 3 is present between first mounting surface 1a of support 1 and the electrodes of electronic component 2. For example, cream solder can be used as solder 3 that bonds support 1 and electronic component 2. Specifically, a Sn-Ag-Cu-based cream solder can be used as solder 3. In the present embodiment, lead-free solder paste manufactured by Nihon Superior Co., Ltd. (product number: SN97C (composition: Sn 96.5%, Ag 3%, Cu 0.5%, melting point: 218 degrees Celsius to 219 degrees Celsius)) was used as the Sn-Ag-Cu-based cream solder.

Electronic component 2 is mounted on first mounting surface 1a of support 1 via solder 3. At this time, since first mounting surface 1a of support 1 is an inclined surface that is inclined relative to second mounting surface 1b, electronic component 2 mounted on first mounting surface 1a is in an inclined orientation when mounted on support 1. As a result, when inclined mounting module 100 is mounted on a board, electronic component 2 is inclined relative to a principal surface of the board.

For example, when electronic component 2 is a solid-state light-emitting element, an illumination module capable of outputting, in an oblique direction relative to the principal surface of the board, light emitted by the solid-state light-emitting element can be obtained as inclined mounting module 100. Further, when electronic component 2 is a detection element, a sensor module capable of detecting physical properties (such as light) incident in an oblique direction relative to the principal surface of the board can be obtained as inclined mounting module 100.

Thus, according to inclined mounting module 100 of the present embodiment, it is possible to achieve favorable efficiency in: utilizing the active characteristic of electronic component 2 in an oblique direction relative to the principal surface of the board; or utilizing the passive characteristic of electronic component 2 with respect to physical properties arriving from an oblique direction relative to the principal surface of the board.

Note that the outer contour shape of at least one of first electrode 11 or second electrode 12 exposed on first mounting surface 1a of support 1 may be the same as or substantially the same as the outer contour shape of one of the first electrode or the second electrode exposed on the mounting surface of electronic component 2 that is bonded via solder 3. Accordingly, one of the first electrode or the second electrode exposed on the mounting surface of electronic component 2 is bonded by molten solder 3 to one of first electrode 11 or second electrode 12 exposed on first mounting surface 1a such that their outer contour shapes match each other. That is, it is possible to inhibit electronic component 2 mounted on first mounting surface 1a from rotating and shifting in position on first mounting surface 1a when molten solder 3 solidifies. Accordingly, inclined mounting module 100 suitable for precise control of the mounting position of electronic component 2 can be obtained.

Moreover, not only one but both of the following may apply: the outer contour shape of first electrode 11 of support 1 exposed on first mounting surface 1a is the same as or substantially the same as the outer contour shape of the first electrode exposed on the mounting surface of electronic component 2; and the outer contour shape of second electrode 12 of support 1 exposed on first mounting surface 1a is the same as or substantially the same as the outer contour shape of the second electrode exposed on the mounting surface of electronic component 2. Accordingly, both the first electrode and the second electrode exposed on the mounting surface of electronic component 2 are bonded by molten solder 3 to first electrode 11 and second electrode 12 of support 1 exposed on first mounting surface 1a such that their outer contour shapes match. Accordingly, inclined mounting module 100 that is even more suitable for precise control of the mounting position of electronic component 2 can be obtained.

Here, an example of a method for manufacturing inclined mounting module 100 will be described with reference to FIG. 5. FIG. 5 is a diagram for describing an example of a method for manufacturing inclined mounting module 100 according to Embodiment 1.

First, as illustrated in (a) of FIG. 5, support 1 is disposed at an angle so as to make first mounting surface 1a horizontal.

Next, as illustrated in (b) of FIG. 5, solder 3 is applied to first mounting surface 1a of support 1 by a dispenser device. The amount of solder 3 applied is, for example, an amount that makes the thickness of solder 3 approximately 80 µm after reflow. Cream solder (solder paste) can be used as solder 3. Solder 3 is applied to metal portions (first electrode 11 and second electrode 12) exposed on first mounting surface 1a of support 1. In this case, solder 3 is applied separately to first electrode 11 and second electrode 12. That is, solder 3 is applied to two locations on first mounting surface 1a so that solder 3 on first electrode 11 and solder 3 on second electrode 12 do not merge into one. Note that, although solder 3 is applied only to first electrode 11 and second electrode 12 that are exposed on first mounting surface 1a, solder 3 may also be applied to portions of first mounting surface 1a other than first electrode 11 and second electrode 12.

Next, as illustrated in (c) of FIG. 5, electronic component 2 is placed on solder 3 applied to support 1. At this time, electronic component 2 adheres to first mounting surface 1a of support 1 via solder 3 by the adhesive force of solder 3. When electronic component 2 is a white LED package, electronic component 2 (LED package) is placed on support 1 such that a first electrode (for example, a positive electrode) and a second electrode (for example, a negative electrode) of the white LED package face first electrode 11 and second electrode 12 of support 1.

Next, as illustrated in (d) of FIG. 5, support 1 is rotated so that second mounting surface 1b becomes horizontal. At this time, although first mounting surface 1a is inclined relative to the horizontal plane (XY plane), electronic component 2 does not slide down because it is adhered to solder 3.

Thereafter, support 1 is introduced into a reflow apparatus (reflow furnace) while maintaining the posture illustrated in (d) of FIG. 5, and is heated under a temperature condition at which solder 3 melts, thereby melting solder 3. After that, solder 3 is solidified. By doing so, electronic component 2 can be bonded to first mounting surface 1a of support 1 via solder 3.

At this time, as illustrated in (e) of FIG. 5, since first mounting surface 1a of support 1 is inclined relative to the horizontal plane (XY plane), solder 3 is melted by heat during reflow and wets and spreads over first mounting surface 1a (specifically, the surfaces of first electrode 11 and second electrode 12 exposed), whereby electronic component 2 temporarily slides down along the inclination of first mounting surface 1a in a direction in which the distance between first mounting surface 1a and second mounting surface 1b decreases (that is, the lower side of first mounting surface 1a). Specifically, since first electrode edge 11S and second electrode edge 12S of support 1 are spaced apart from second mounting surface 1b in a direction orthogonal to second mounting surface 1b, electronic component 2 slides down in a manner that the lower end portion of electronic component 2 (for example, first electrode edge 2aS and second electrode edge 2bS) protrudes from first electrode edge 11S and second electrode edge 12S of support 1. In such a manner, electronic component 2 temporarily slides down along first mounting surface 1a; however, since melted solder 3 is acted on by a force tending to reduce its volume as much as possible, electronic component 2, as illustrated in (f) of FIG. 5, slides up along the inclination of first mounting surface 1a and is mounted at its predetermined mounting position on support 1 by this action. In other words, using first electrode edge 11S and second electrode edge 12S as alignment references, the electrodes of electronic component 2 are automatically aligned with first electrode 11 and second electrode 12 of support 1. Specifically, first electrode edge 2aS of the first electrode of electronic component 2 on the lower side of the inclined surface is aligned with first electrode edge 11S of support 1, and second electrode edge 2bS of the second electrode of electronic component 2 on the lower side of the inclined surface is aligned with second electrode edge 12S of support 1.

Note that, in the present embodiment, the predetermined mounting position of electronic component 2 on support 1 is a position at which the lower end of inclined first mounting surface 1a substantially coincides with an end of electronic component 2 located on the lower side of the inclined surface. In other words, the predetermined mounting position of electronic component 2 is a position at which the respective ends of first electrode edge 11S and second electrode edge 12S of support 1 substantially coincide with the respective ends of first electrode edge 2aS and second electrode edge 2bS of electronic component 2, respectively.

On first mounting surface 1a of support 1, each of first electrode 11 and second electrode 12 extends in the inclination direction of first mounting surface 1a. This makes it possible, in (e) of FIG. 5, to facilitate movement of electronic component 2 along the inclination direction and to inhibit movement of electronic component 2 in directions other than the inclination direction that would cause positional displacement of electronic component 2. For example, it is possible to inhibit positional displacement of electronic component 2 in a direction orthogonal to the inclination direction.

Note that, in (e) of FIG. 5, there is a risk that electronic component 2 may fall off first mounting surface 1a when solder 3 melts; however, since solder 3 acts to restrain electronic component 2 at first electrode edge 11S and second electrode edge 12S serving as alignment references, electronic component 2 does not fall off first mounting surface 1a. This makes it possible to prevent positional displacement of electronic component 2 caused by electronic component 2 falling off first mounting surface 1a that is the inclined surface on which electronic component 2 is placed, and electronic component 2 can be mounted on support 1 while electronic component 2 is in an inclined state, without displacement from the predetermined mounting position on support 1. In such a manner, the mounting position of electronic component 2 bonded to support 1 is automatically aligned to the position determined by first electrode edge 11S and second electrode edge 12S that serve as alignment references.

Inclined mounting module 100 in which electronic component 2 is mounted on support 1 via solder 3 can be fabricated as described above. Specifically, first electrode 11 and second electrode 12 in support 1 are connected to the first electrode and the second electrode of electronic component 2 that is a white LED package. By actually fabricating inclined mounting module 100 using this method, inclined mounting module 100 illustrated in FIG. 6 was obtained. FIG. 6 is an optical photograph showing a side view of inclined mounting module 100 that was actually fabricated. As illustrated in FIG. 6, it can be seen that electronic component 2 was able to be mounted at its predetermined mounting position on first mounting surface 1a of support 1.

Note that, in FIG. 5, support 1 was initially inclined so as to make first mounting surface 1a horizontal, but the present disclosure is not limited thereto. Specifically, as illustrated in (a) of FIG. 7, first mounting surface 1a may initially be inclined relative to the horizontal plane (XY plane). FIG. 7 is a diagram for describing another example of the method for manufacturing inclined mounting module 100 according to Embodiment 1.

In this method, first, as illustrated in (a) of FIG. 7, support 1 is disposed so as to make second mounting surface 1b horizontal. At this time, first mounting surface 1a is inclined relative to the horizontal plane (XY plane). Next, as illustrated in (b) of FIG. 7, solder 3 is applied to first mounting surface 1a of support 1 as in (b) of FIG. 5. Next, as illustrated in (c) of FIG. 7, electronic component 2 is placed on solder 3 applied to support 1. At this time, electronic component 2 does not slide down because it adheres to first mounting surface 1a of support 1 by the adhesive force of solder 3. Thereafter, support 1 is introduced into a reflow apparatus, and solder 3 is melted and solidified so as to bond electronic component 2 to support 1. At this time, as illustrated in (d) and (e) of FIG. 7, as in (e) and (f) of FIG. 5, solder 3 melts, and wets and spreads over first mounting surface 1a, whereby electronic component 2 slides down along the inclination of first mounting surface 1a; however, since melted solder 3 is acted on by a force tending to reduce its volume as much as possible, electronic component 2 slides up along the inclination of first mounting surface 1a and is mounted at its predetermined mounting position on support 1.

Next, circuit module 200 including inclined mounting module 100 will be described with reference to FIG. 8 and FIG. 9. FIG. 8 is a perspective view illustrating a portion of circuit module 200 according to Embodiment 1. FIG. 9 is a side view illustrating a portion of circuit module 200 according to Embodiment 1.

As illustrated in FIG. 8 and FIG. 9, circuit module 200 can be obtained by mounting inclined mounting module 100 on circuit board 4. That is, circuit module 200 includes inclined mounting module 100 and circuit board 4 on which support 1 in inclined mounting module 100 is mounted.

As illustrated in FIG. 8 and FIG. 9, in circuit module 200, support 1 of inclined mounting module 100 is mounted on circuit board 4 via second mounting surface 1b of support 1. Support 1 that supports electronic component 2 is mounted by disposing second mounting surface 1b of support 1 on circuit board 4. Thus, support 1 is a support member that is mounted on circuit board 4 while supporting electronic component 2.

When mounting inclined mounting module 100 on circuit board 4, support 1 of inclined mounting module 100 is mounted on circuit board 4 by a soldering-based mounting technique using solder. Thus, as illustrated in FIG. 9, solder 5 is present between second mounting surface 1b of support 1 and circuit board 4. Solder 5 is a bonding material that bonds first electrode 11 and second electrode 12 exposed on second mounting surface 1b of support 1 to electrodes 4a of the pattern on circuit board 4. Note that solder 5 is omitted in FIG. 8.

In the present embodiment, solder 5 used when support 1 is mounted on circuit board 4 and solder 3 used when electronic component 2 is mounted on support 1 are the same type of solder having substantially the same melting point. Specifically, solder 5 used when support 1 is mounted on circuit board 4 and solder 3 used when electronic component 2 is mounted on support 1 are the same.

At least one inclined mounting module 100 is mounted on circuit board 4. Circuit board 4 is an example of the board. Circuit board 4 is a mounting board used for mounting support 1. Circuit board 4 includes a first surface, which is a principal surface on which support 1 is mounted, and a second surface, which is a principal surface opposite to the first surface.

In the present embodiment, circuit board 4 is a printed wiring board on which electrodes 4a having a predetermined pattern (electrode pattern) are formed. Electrodes 4a are formed on the first surface of circuit board 4, which is one principal surface of circuit board 4. Note that circuit board 4 may be a double-sided wiring board having wiring formed on both surfaces. Circuit board 4 is, for example, a resin board having an electrically insulating resin material as the base material, a ceramic board having a ceramic material such as alumina as the base material, or a metal-based board having a metal material such as aluminum or copper as the base material. Note that circuit board 4 is a rigid board but may be a flexible board. In the present embodiment, the shape of circuit board 4 in a plan view is rectangular, but is not limited thereto. The shape of circuit board 4 in a plan view may be a polygon such as a rectangle, or may be circular, or may be another shape. The thickness of circuit board 4 is not particularly limited.

Since support 1 having electronic component 2 disposed thereon in an inclined orientation is mounted on circuit board 4, electronic component 2 is inclined relative to the principal surface of circuit board 4. Therefore, circuit module 200 is a module in which electronic component 2 is mounted on first mounting surface 1a inclined relative to second mounting surface 1b via which support 1 is mounted on circuit board 4.

Accordingly, when electronic component 2 has an active characteristic, it is possible to implement circuit module 200 capable of utilizing the active characteristic in an oblique direction relative to the principal surface of circuit board 4. When electronic component 2 has a passive characteristic, it is possible to implement circuit module 200 capable of receiving, by electronic component 2, physical properties arriving from an oblique direction relative to the principal surface of circuit board 4.

For example, when electronic component 2 is a solid-state light-emitting element, circuit module 200 having an active function suitable for outputting light in an oblique direction relative to the principal surface (mounting surface) of circuit board 4 can be obtained. When electronic component 2 is a detection element, circuit module 200 having a passive function suitable for detecting physical properties arriving from an oblique direction relative to the principal surface (mounting surface) of circuit board 4 can be obtained.

Thus, according to circuit module 200 of the present embodiment, it is possible to achieve favorable efficiency in: utilizing the active characteristic of electronic component 2 in an oblique direction relative to the principal surface of circuit board 4; or utilizing the passive characteristic of electronic component 2 with respect to physical properties arriving from an oblique direction relative to the principal surface of circuit board 4.

As described above, in support 1, first electrode 11 and second electrode 12 are exposed on each of first mounting surface 1a and second mounting surface 1b. Accordingly, heat generated by electronic component 2 mounted on first mounting surface 1a of support 1 is conducted by first electrode 11 and second electrode 12 and efficiently transmitted to circuit board 4 via second mounting surface 1b of support 1. Thus, first electrode 11 and second electrode 12, which are metal structures having a height with respect to circuit board 4, are structures that also serve as the positive and negative electrodes of electronic component 2 and can be used as heat conduction paths in a direction perpendicular to the principal surface of circuit board 4. This facilitates heat dissipation design using a metal structure having a height, and performance degradation due to temperature rise of incline-mounted electronic component 2 can be suppressed while achieving high-density mounting. That is, according to support 1 of the present embodiment, it is possible to effectively suppress performance degradation caused by high-density mounting of electronic component 2 that is incline-mounted.

Now, an example of a method for manufacturing circuit module 200 illustrated in FIG. 8 and FIG. 9 will be described with reference to FIG. 10. FIG. 10 is a diagram for describing an example of a method for manufacturing circuit module 200 according to Embodiment 1.

The method for manufacturing circuit module 200 illustrated in FIG. 10 includes a first placing process illustrated in (a) and (b) of FIG. 10, a second placing process illustrated in (c) and (d) of FIG. 10, and a mounting process illustrated in (e) and (f) of FIG. 10.

In the first placing process, electronic component 2 is placed on first mounting surface 1a of support 1 via solder 3 (first solder). Specifically, first, as illustrated in (a) of FIG. 10, solder 3 is applied to first mounting surface 1a of support 1 by a dispenser device. At this time, although solder 3 is applied only to the metal portions (first electrode 11 and second electrode 12) of first mounting surface 1a of support 1, solder 3 may also be applied to locations on first mounting surface 1a other than first electrode 11 and second electrode 12. Next, as illustrated in (b) of FIG. 10, electronic component 2 is placed on solder 3 applied to support 1. At this time, electronic component 2 adheres to first mounting surface 1a of support 1 via solder 3 by the adhesive force of solder 3. When electronic component 2 is a white LED package, electronic component 2 (LED package) is placed on support 1 such that a first electrode (for example, a positive electrode) and a second electrode (for example, a negative electrode) of the white LED package face first electrode 11 and second electrode 12 of support 1.

In the second placing process, support 1 is placed on electrodes 4a of circuit board 4 via solder 5 (second solder). Specifically, first, as illustrated in (c) of FIG. 10, solder 5 is applied onto electrodes 4a of circuit board 4 by a dispenser device. The same type of solder as solder 3 used in the first placing process, for example, can be used as solder 5. Next, although not illustrated, a suction nozzle is attached to suction portion 20 of support 1 by suction, and, as illustrated in (d) of FIG. 10, places, on solder 5 applied to circuit board 4, support 1 having electronic component 2 placed thereon.

In the mounting process, electronic component 2 is mounted on support 1 using solder 3, and support 1 is mounted on circuit board 4 using solder 5. Specifically, a structural body in which electronic component 2 is placed on support 1 via solder 3 and support 1 is placed on circuit board 4 via solder 5 is introduced into a reflow apparatus (reflow furnace) and heated under a temperature condition at which solder 3 and 5 melt, thereby melting solder 3 and 5, and thereafter, solder 3 and 5 are solidified. By doing so, electronic component 2 can be bonded to first mounting surface 1a of support 1 via solder 3, and support 1 can be bonded via solder 5 to circuit board 4 via second mounting surface 1b.

At this time, as illustrated in (e) of FIG. 10, since first mounting surface 1a of support 1 is inclined relative to the horizontal plane (XY plane), solder 3 is melted by heat during reflow and wets and spreads over first mounting surface 1a (specifically, the surfaces of first electrode 11 and second electrode 12 exposed), whereby electronic component 2 temporarily slides down along the inclination of first mounting surface 1a. Specifically, since first electrode edge 11S and second electrode edge 12S of support 1 are spaced apart from second mounting surface 1b in a direction orthogonal to second mounting surface 1b, electronic component 2 slides down in a manner that the lower end portion of electronic component 2 (for example, first electrode edge 2aS and second electrode edge 2bS) protrudes from first electrode edge 11S and second electrode edge 12S of support 1. In such a manner, electronic component 2 temporarily slides down along first mounting surface 1a; however, since melted solder 3 is acted on by a force tending to reduce its volume as much as possible, electronic component 2, as illustrated in (f) of FIG. 10, slides up along the inclination of first mounting surface 1a and is mounted at its predetermined mounting position on support 1 by this action. In other words, using first electrode edge 11S and second electrode edge 12S as alignment references, the electrodes of electronic component 2 are automatically aligned with first electrode 11 and second electrode 12 of support 1. Specifically, first electrode edge 2aS of the first electrode of electronic component 2 on the lower side of the inclined surface is aligned with first electrode edge 11S of support 1, and second electrode edge 2bS of the second electrode of electronic component 2 on the lower side of the inclined surface is aligned with second electrode edge 12S of support 1.

Note that since second mounting surface 1b of support 1 is parallel to the horizontal plane (XY plane), support 1 does not move even if heat during reflow causes solder 5 to melt, wet, and spread between second mounting surface 1b and circuit board 4.

Circuit module 200 in which electronic component 2 is mounted on support 1 via solder 3 and support 1 is mounted on circuit board 4 via solder 5 can be fabricated as described above. Specifically, first electrode 11 and second electrode 12 in support 1 are connected to the first electrode and the second electrode of electronic component 2 that is a white LED package, and first electrode 11 and second electrode 12 in support 1 are also connected to a pair of electrodes 4a of circuit board 4.

In the present embodiment, the mounting process illustrated in (e) and (f) of FIG. 10 is performed after the first placing process illustrated in (a) and (b) of FIG. 10 and the second placing process illustrated in (c) and (d) of FIG. 10. In this case, the order of the first placing process and the second placing process is not particularly limited. For example, although the second placing process is performed after the first placing process in the present embodiment, the first placing process may be performed after the second placing process, or the first placing process and the second placing process may be performed simultaneously. That is, support 1 having electronic component 2 placed thereon via solder 3 may be placed on circuit board 4 via solder 5; electronic component 2 may be placed, via solder 3, on support 1 that has been placed on circuit board 4 via solder 5; or the placement of electronic component 2 via solder 3 and the placement of support 1 on circuit board 4 via solder5 may be performed simultaneously.

In the mounting process illustrate in (e) and (f) of FIG. 10, there is a risk that electronic component 2 may fall off first mounting surface 1a when solder 3 melts; however, since solder 3 acts to restrain electronic component 2 at first electrode edge 11S and second electrode edge 12S serving as alignment references, electronic component 2 does not fall off first mounting surface 1a. This makes it possible to prevent positional displacement of electronic component 2 caused by electronic component 2 falling off first mounting surface 1a that is the inclined surface on which electronic component 2 is placed, and electronic component 2 can be mounted on support 1 and support 1 can be mounted on circuit board 4 while electronic component 2 is in an inclined state, without displacement from the predetermined mounting position on support 1. In such a manner, the mounting position of electronic component 2 bonded to support 1 is automatically aligned to the position determined by first electrode edge 11S and second electrode edge 12S that serve as alignment references. Thus, according to the method for manufacturing circuit module 200 in the present embodiment, it is possible to manufacture circuit module 200 in which electronic component 2 is mounted on support 1 by a simple process with high mounting accuracy.

According to the manufacturing method illustrated in FIG. 10, it is possible to fabricate circuit module 200 in which electronic component 2 is incline-mounted on circuit board 4, by simply introducing, into the reflow apparatus once, circuit board 4 on which support 1 supporting electronic component 2 has been placed.

In the present embodiment, when entire first mounting surface 1a is viewed from a direction parallel to second mounting surface 1b, support 1 has a configuration in which the maximum width of the upper half of first mounting surface 1a is equal to the maximum width of the lower half of first mounting surface 1a. Accordingly, when a plurality of inclined mounting modules 100 each of which includes electronic component 2 mounted on support 1 are mounted on circuit board 4 at high density, the ratio of the mounting area of electronic components 2 to the mounting area of inclined mounting modules 100 on circuit board 4 can be increased.

Note that in FIG. 10, circuit module 200 is manufactured by mounting electronic component 2 on support 1 and mounting support 1 on circuit board 4 in a single mounting process; however, the present disclosure is not limited thereto. That is, circuit module 200 may be manufactured by separately performing the process of mounting electronic component 2 on support 1 and the process of mounting support 1 on circuit board 4. This manufacturing method will be described with reference to FIG. 11. FIG. 11 is a diagram for describing another example of the method for manufacturing circuit module 200 according to Embodiment 1.

The method for manufacturing circuit module 200 illustrated in FIG. 11 includes a first mounting process illustrated in (a) of FIG. 11, an inclining process illustrated in (b) of FIG. 11, and a second mounting process illustrated in (c) of FIG. 11.

The first mounting process illustrated in (a) of FIG. 11 is a process of mounting electronic component 2 on first mounting surface 1a of support 1 via solder 3, and is the same as the processes illustrated in (a) through (f) of FIG. 5. Specifically, in the first mounting process, solder 3 is applied to first mounting surface 1a of support 1 that has been disposed so as to make first mounting surface 1a parallel to the horizontal plane (XY plane), and then electronic component 2 is placed on solder 3. Then, support 1 on which electronic component 2 has been placed via solder 3 is introduced into the reflow apparatus to melt solder 3, and thereafter solder 3 is solidified. By doing so, electronic component 2 can be bonded to first mounting surface 1a of support 1 via solder 3.

As illustrated in (b) of FIG. 11, in the inclining process, support 1 having electronic component 2 mounted thereon is inclined. Specifically, support 1 is inclined by rotating support 1 having electronic component 2 mounted thereon so as to make second mounting surface 1b parallel to the horizontal plane (XY plane).

As illustrated in (c) of FIG. 11, in the second mounting process, support 1 having electronic component 2 mounted thereon is mounted on electrodes 4a of circuit board 4 via second mounting surface 1b. Specifically, in the second mounting process, solder 5 is applied onto electrodes 4a of circuit board 4 that is disposed so as to make the principal surface parallel to the horizontal plane (XY plane), a suction nozzle is attached by suction to suction portion 20 of support 1 having electronic component 2 mounted thereon, support 1 having electronic component 2 mounted thereon is placed on solder 5, circuit board 4 on which support 1 having electronic component 2 mounted thereon has been placed is introduced into the reflow apparatus to melt solder 5, and thereafter solder 5 is solidified. By doing so, support 1 that supports electronic component 2 can be bonded to electrodes 4a of circuit board 4 via solder 5. Note that solder 5 used in the second mounting process is the same as solder 3 used in the first mounting process, but is not limited thereto.

In the method for manufacturing circuit module 200 according to the present embodiment, the inclining process is performed after the first mounting process, and the second mounting process is performed after the inclining process. That is, the inclining process is performed between the first mounting process and the second mounting process.

A first mounting direction in which electronic component 2 is mounted on support 1 in the first mounting process (the direction of arrow A in (a) of FIG. 11) and a second mounting direction in which support 1 is mounted on electrodes 4a of circuit board 4 in the second mounting process (the direction of arrow B in (c) of FIG. 11) are the same direction. In the present embodiment, the first mounting direction (the direction of arrow A) and the second mounting direction (the direction of arrow B) are the direction of gravity (Z-axis direction).

Note that in the second mounting process illustrated in (c) of FIG. 11, not only does solder 5 between circuit board 4 and support 1 melt, but solder 3 between electronic component 2 and support 1 also melts. At this time, there is a risk that electronic component 2 placed on first mounting surface 1a that is inclined may fall in a direction in which the distance between first mounting surface 1a and second mounting surface 1b decreases (that is, the lower side of first mounting surface 1a); however, since solder 3 acts to restrain electronic component 2 at first electrode edge 11S and second electrode edge 12S serving as alignment references, electronic component 2 does not fall off first mounting surface 1a. Accordingly, it is possible to prevent positional displacement of electronic component 2 that occurs if electronic component 2 placed on first mounting surface 1a that is inclined falls off first mounting surface 1a. In such a manner, the mounting position of electronic component 2 bonded to support 1 is automatically aligned to the position determined by first electrode edge 11S and second electrode edge 12S that serve as alignment references. Therefore, it is possible to mount electronic component 2 on support 1 and mount support 1 on circuit board 4 using the same type of mounting machine and with a minimum number of mounting flows, without changing the type of solder and the reflow temperature.

Thus, in the method for manufacturing circuit module 200 illustrated in FIG. 11, electronic component 2 can be mounted on support 1 and support 1 can be mounted on circuit board 4 while electronic component 2 is in the inclined state, without electronic component 2 placed on first mounting surface 1a of support 1 being displaced from its predetermined position. Therefore, in the method for manufacturing circuit module 200 illustrated in FIG. 11, it is possible to manufacture circuit module 200 in which electronic component 2 is mounted on support 1 by a simple process with high mounting accuracy.

The envelope volume of circuit module 200 according to the present embodiment is, for example, at least 1 cm³ and at most 1 m³, preferably at least 3 cm³ and at most 30000 cm³, and more preferably at least 1000 cm³ and at most 10000 cm³. By imparting such an envelope volume to circuit module 200, circuit module 200 becomes suitable for configuring an LED illumination device or a detection device, for example.

Also, in circuit module 200 illustrated in FIG. 8 and FIG. 9, one inclined mounting module 100 is disposed on one circuit board 4; however, the present disclosure is not limited thereto. Specifically, as in circuit module 201 illustrated in FIG. 12, a plurality of inclined mounting modules 100 may be disposed on one circuit board 4. In this case, as illustrated in FIG. 12, a plurality of the same inclined mounting modules 100 may be mounted on circuit board 4. Note that electrodes 4a of circuit board 4 are omitted in FIG. 12. The same applies hereinafter.

Further, in circuit module 201 illustrated in FIG. 12, inclined mounting modules 100 are mounted such that first mounting surfaces 1a (inclined surfaces) of supports 1 are oriented in the same direction and that the mounting density is uniform. By doing so, the plurality of electronic components 2 mounted on the plurality of supports 1 are oriented in one direction; therefore, circuit module 201 suitable for providing an active or passive characteristic with high directivity can be obtained.

Note that FIG. 12 illustrates a case in which inclined mounting modules 100 are mounted at intersections of a grid. With this configuration, the front of electronic components 2 obliquely mounted on supports 1 tends to be blocked by inclined mounting modules 100 mounted in a preceding row. To avoid this adverse effect, inclined mounting modules 100 may be disposed at intersections of an oblique grid. By doing so, inclined mounting modules 100 in the preceding row are mounted at positions offset from the front of electronic components 2 obliquely mounted on supports 1; therefore, inclined mounting modules 100 located two rows ahead are disposed in front. As a result, a space can be secured in front of each of incline-mounted electronic components 2, thus achieving both high-density mounting and an active or passive characteristic with high directivity.

FIG. 12 illustrates a case where inclined mounting modules 100 are mounted in a planar arrangement; however, depending on the application, inclined mounting modules 100 may be mounted in a linear arrangement. In this case, first mounting surfaces 1a of supports 1 may be arranged in a single column or in a single row. At this time, the directions of output light emitted from the plurality of inclined mounting modules 100 mounted on circuit board 4 may be the same or different. Further, inclined mounting modules 100 may be disposed so as to emit output light in a regular pattern in two or more different directions. In this case, the two or more different directions may be directions having different inclination angles relative to the board surface of circuit board 4, or directions having different rotation angles on the board surface of circuit board 4. Multiple variations are possible. For example, inclined mounting modules 100 may be disposed such that the inclination angles or rotation angles alternately differ.

Also, in circuit module 202 illustrated in FIG. 13, as in circuit module 201 illustrated in FIG. 12, a plurality of the same inclined mounting modules 100 are mounted on one circuit board 4, but first mounting surfaces 1a (inclined surfaces) of supports 1 in the respective inclined mounting modules 100 face different directions. Specifically, inclined mounting modules 100 are disposed such that first mounting surfaces 1a of supports 1 face the outer peripheral edge of circuit board 4. Further, in circuit module 202 illustrated in FIG. 13, a plurality of electronic components 2 that are not incline-mounted are disposed in the central portion of circuit board 4. That is, a plurality of electronic components 2 that are incline-mounted and a plurality of electronic components 2 that are not incline-mounted coexist. Note that the plurality of inclined mounting modules 100 and the plurality of electronic components 2 that are not incline-mounted are mounted on circuit board 4 such that the overall mounting density is uniform.

In circuit module 203 illustrated in FIG. 14, circular plate-shaped circuit board 4A is used, and a plurality of inclined mounting modules 100 and electronic component 2 that is not incline-mounted are both mounted on this circuit board 4A. The plurality of inclined mounting modules 100 are disposed such that first mounting surfaces 1a (inclined surfaces) of supports 1 face the outer peripheral edge of circuit board 4A. Electronic component 2 that is not incline-mounted is disposed in the central portion of circuit board 4A and is surrounded by the plurality of inclined mounting modules 100. Note that the plurality of inclined mounting modules 100 and electronic component 2 that is not incline-mounted are mounted on circuit board 4A in a manner that the overall mounting density is uniform.

According to circuit module 203 illustrated in FIG. 14, when all electronic components 2 are solid-state light-emitting elements, it is possible to efficiently illuminate both the direction perpendicular to the principal surface (mounting surface) of circuit board 4A and the obliquely upward directions relative to the outer peripheral portion of circuit board 4A. Accordingly, circuit module 203 functioning as a surface light source that can emit intense output light in oblique directions can be obtained without disposing optical components such as lenses or reflectors, thus enabling resource saving and miniaturization of lighting fixtures.

When all electronic components 2 in circuit module 203 illustrated in FIG. 14 are detection elements, it is possible to implement circuit module 203 capable of simultaneously detecting physical properties (such as light) incident from the direction perpendicular to the principal surface (mounting surface) of circuit board 4A and from the obliquely upward directions relative to the outer peripheral portion of circuit board 4A. Accordingly, circuit module 203 capable of monitoring the physical properties over 360 degrees can be obtained.

Also, in circuit module 204 illustrated in FIG. 15 and FIG. 16, a plurality of inclined mounting modules whose first mounting surfaces 1a (inclined surfaces) have different inclination angles are mounted on circuit board 4. Specifically, as illustrated in FIG. 15 through FIG. 17, circuit module 204 includes: inclined mounting modules 100 (first inclined mounting modules) each having support 1 according to Embodiment 1; inclined mounting modules 100A (second inclined mounting modules) each having support 1A whose first mounting surface 1a is larger in inclination angle than that of inclined mounting modules 100 (first inclined mounting modules); and inclined mounting modules 100B (third inclined mounting modules) each having support 1B whose first mounting surface 1a is smaller in inclination angle than that of inclined mounting modules 100 (first inclined mounting modules).

A plurality of inclined mounting modules 100, a plurality of inclined mounting modules 100A, and a plurality of inclined mounting modules 100B are mounted, and the plurality of inclined mounting modules 100, 100A, and 100B are disposed such that their first mounting surfaces 1a (inclined surfaces) of the same group of inclined mounting modules face the same straight line. Also, inclined mounting modules 100, 100A, and 100B are each mounted such that the larger the inclination angle of first mounting surface 1a, the larger the non-mounting space in front of it. Specifically, the non-mounting space in front of each of inclined mounting modules 100A is larger than the non-mounting space in front of each of inclined mounting modules 100.

According to circuit module 204 illustrated in FIG. 15 and FIG. 16, when electronic components 2 are solid-state light-emitting elements, physical properties (such as light) can be emitted toward the same straight line. Also, when electronic components 2 are detection elements, physical properties (such as light) emitted from the same straight line can be detected. Accordingly, it is possible to implement circuit module 204 that is compact and features high-density mounting.

Note that in FIG. 15, inclined mounting modules 100, 100A, and 100B are disposed in a manner that first mounting surfaces 1a (inclined surfaces) of the same group of inclined mounting modules face the same straight line; however, the present disclosure is not limited thereto. For example, inclined mounting modules 100, 100A, and 100B may be disposed in a manner that first mounting surfaces 1a of the same group of inclined mounting modules face the same single point.

Further, in circuit module 205 illustrated in FIG. 18, a plurality of inclined mounting modules whose first mounting surfaces 1a (inclined surfaces) have different surface areas are mounted on circuit board 4. Specifically, as illustrated in FIG. 18, circuit module 205 includes: inclined mounting module 100 including support 1 according to Embodiment 1 (first inclined mounting module); and inclined mounting modules 100C (fourth inclined mounting modules) each including support 1C whose first mounting surface 1a is larger than first mounting surface 1a of support 1 in surface area. In the present variation, a plurality of inclined mounting modules 100C are mounted. In this case, a plurality of types of inclined mounting modules 100C whose first mounting surfaces 1a have different surface areas are mounted. A plurality of electronic components 2 are mounted on one support 1C included in each inclined mounting module 100C. Specifically, the following inclined mounting modules 100C are included: inclined mounting modules 100C in each of which two electronic components 2 are mounted on support 1C; inclined mounting module 100C in which three electronic components 2 are mounted on support 1C; and inclined mounting module 100C in which four electronic components 2 are mounted on support 1C. Each inclined mounting module 100C includes a plurality of first electrodes 11 and a plurality of second electrodes 12 corresponding to the plurality of electronic components 2. Note that, in the present variation, the inclination angle of first mounting surface 1a of support 1 in inclined mounting module 100 and the inclination angle of first mounting surface 1a of support 1C in each inclined mounting module 100C are the same, but may be different.

According to circuit module 205 illustrated in FIG. 18, a plurality of electronic components 2 are mounted per inclined mounting module 100C; therefore, the number of times mounting is performed for inclined mounting module 100 can be reduced. Also, since the mounting distribution of inclined mounting modules 100C on circuit board 4 can be readily designed according to the application, it is possible to implement circuit module 205 having excellent industrial producibility and responsiveness to customer requests.

Generally, circuit board 4 is made of a resin material having an electrically insulating property from the viewpoint of preventing electrical short circuits of electronic components 2; however, since resin materials generally have lower thermal conductivity than metal materials, designing heat dissipation for heat-generating electronic components 2 tends to be challenging. Meanwhile, circuit board 4 is in the shape of a flat plate in general, so if a plurality of electronic components 2 are mounted on circuit board 4, heat is not readily conducted in the direction along the horizontal plane of the principal surface of circuit board 4, thus imposing constraints on how close electronic components 2 can be placed. To address this, inclined mounting module 100 in the present embodiment includes support 1 capable of achieving both high-density mounting and suppression of performance degradation caused by temperature rise of incline-mounted electronic components 2; therefore, inclined mounting module 100 is advantageous for high-density mounting. For example, the mounting density of electronic components 2 can be greater than one component/cm², and further can be greater than three components/cm². Accordingly, since electronic components 2 can be mounted at high density, circuit module 205 that is compact and enables miniaturization of electronic devices can be obtained.

Note that in the circuit modules illustrated in FIG. 12 through FIG. 18, the plurality of electronic components 2 are all the same; however, the present disclosure is not limited thereto. For example, the circuit modules illustrated in FIG. 12 through FIG. 18 may include both inclined mounting modules in which electronic components 2 are solid-state light-emitting elements and inclined mounting modules in which electronic components 2 are detection elements. Also, in the circuit modules illustrated in FIG. 12 through FIG. 18, the mounting density of inclined mounting modules and electronic components 2 can be high or low according to the application or customer requests. Further, inclined mounting modules and electronic components 2 may be mounted in a manner that their in-plane distributions within the principal surface of the circuit board are uniform or non-uniform.

Next, electronic device 300 according to the present embodiment will be described with reference to FIG. 19. FIG. 19 is a perspective view of electronic device 300 according to Embodiment 1.

As illustrated in FIG. 19, electronic device 300 according to the present embodiment includes circuit module 201 illustrated in FIG. 12. Circuit module 201 includes a plurality of inclined mounting modules 100 mounted on circuit board 4. Thus, electronic device 300 includes inclined mounting modules 100.

With this configuration, electronic device 300 including electronic components 2 that are mounted at an angle relative to the principal surface of circuit board 4 can be obtained. Accordingly, it is possible to implement electronic device 300 having favorable efficiency in: utilizing the active characteristics of electronic components 2 in an oblique direction relative to the principal surface of circuit board 4; and utilizing the passive characteristics of electronic components 2 with respect to physical properties arriving from an oblique direction relative to the principal surface of circuit board 4.

For example, electronic device 300 illustrated in FIG. 19 is an illumination device in which electronic components 2 are solid-state light-emitting elements (for example, LEDs or semiconductor lasers). Circuit module 201 is fixed to base 6a that serves as a heat sink. Circuit module 201 may include a lighting circuit (not illustrated) for the solid-state light-emitting elements. Note that, although not illustrated, electronic device 300 includes a light-transmissive cover that covers circuit module 201. Electric power is supplied to circuit module 201 via power feeding line 6b. This enables electronic components 2 (solid-state light-emitting elements) to emit light. Note that electronic device 300 includes mounting brackets 6c for fixing electronic device 300 to a building.

In electronic device 300 configured as described above, since electronic components 2 of circuit module 201 that serve as solid-state light-emitting elements are mounted at an angle relative to the principal surface of circuit board 4, electronic components 2 serving as solid-state light-emitting elements emit light in an oblique direction relative to the principal surface of circuit board 4. This light is the illumination light of electronic device 300 serving as an illumination device. Thus, an illumination device capable of emitting intense illumination light in an oblique direction can be implemented.

Further, another example of electronic device 300 according to the present embodiment will be described with reference to FIG. 20. FIG. 20 is a schematic view of electronic device 300X in another example according to Embodiment 1.

Electronic device 300X illustrated in FIG. 20 is a detection device or an evaluation device in which a solid-state light-emitting element and a light detection element are combined as electronic components. Specifically, electronic device 300X includes: inclined mounting module 100 (first inclined mounting module) in which electronic component 2 mounted on support 1 is a solid-state light-emitting element; inclined mounting module 100X (second inclined mounting module) in which electronic component 2X mounted on support 1 is a light detection element; and housing 7 that accommodates inclined mounting modules 100 and 100X. In housing 7, substance 8 is present between electronic component 2 (solid-state light-emitting element) and electronic component 2X (light detection element). Substance 8 is at least one substance selected from a gas, a liquid, and a solid, for example.

In electronic device 300X illustrated in FIG. 20, light emitted from electronic component 2 (solid-state light-emitting element) is received by electronic component 2X (light detection element) via substance 8 and converted into an electrical signal. At this time, electronic component 2X (light detection element) detects: light resulting from scattering, by substance 8, of light emitted from electronic component 2 (solid-state light-emitting element); or light resulting from absorption, by substance 8, of at least part of light emitted from electronic component 2 (solid-state light-emitting element). Thus, by analyzing or parsing the light detected by electronic component 2X (light detection element), it is possible to detect the presence of substance 8 or evaluate the state or the like of substance 8.

### [Embodiment 2]

Next, support 1D and inclined mounting module 100D according to Embodiment 2 will be described with reference to FIG. 21 through FIG. 24. FIG. 21 is a perspective view of support 1D according to Embodiment 2. FIG. 22 is a diagram illustrating the configuration of support 1D according to Embodiment 2. In FIG. 22, (a) is a side view of support 1D, (b) is a front view of support 1D, and (c) is a top view of support 1D. FIG. 23 is a perspective view of inclined mounting module 100D according to Embodiment 2. FIG. 24 is a side view of inclined mounting module 100D according to Embodiment 2.

As illustrated in FIG. 21 and FIG. 22, support 1D according to the present embodiment includes first mounting surface 1a and second mounting surface 1b as in Embodiment 1. Further, support 1D includes first electrode 11, second electrode 12, insulators 13, and fixing body 16. Note that support 1D according to the present embodiment does not include first protector 14 or second protector 15, but may include first protector 14 and second protector 15 as in Embodiment 1.

Fixing body 16 is disposed between first electrode 11 and second electrode 12 via insulator 13. That is, insulator 13 is provided between first electrode 11 and fixing body 16 and between second electrode 12 and fixing body 16.

Since support 1D includes fixing body 16, mechanical strength of support 1D against vibration can be readily ensured. In the present embodiment, fixing body 16 also serves as a heat-dissipating body. That is, fixing body 16 has not only the function of ensuring mechanical strength of support 1D but also the function of dissipating heat generated by electronic component 2 mounted on support 1D. Therefore, fixing body 16 may be made of a metal material in view of both mounting electronic component 2 on support 1D and dissipating heat generated by electronic component 2. Fixing body 16 is, for example, a plate-shaped metal block made of a metal material having high thermal conductivity such as copper or aluminum. Specifically, fixing body 16 is a flat plate-shaped metal block having a constant thickness.

Note that the shape of fixing body 16 is not limited to this and may be mesh-shaped. By making fixing body 16 a mesh-shaped metal member, a mesh surface where the proportion of hard metal portions is reduced is formed; therefore, fixing body 16 can be readily fabricated by punching out a predetermined shape.

As illustrated in FIG. 23 and FIG. 24, inclined mounting module 100D according to the present embodiment includes support 1D and electronic component 2 mounted on first mounting surface 1a of support 1D. Electronic component 2 is mounted on first mounting surface 1a of support 1D via solder 3.

Not only first electrode 11 and second electrode 12 but also fixing body 16 are exposed on first mounting surface 1a and second mounting surface 1b of support 1D. Therefore, heat generated by electronic component 2 mounted on first mounting surface 1a is conducted from first mounting surface 1a to second mounting surface 1b not only via first electrode 11 and second electrode 12 but also via fixing body 16. Accordingly, heat generated by electronic component 2 mounted on first mounting surface 1a can be efficiently dissipated.

In the present embodiment, insulator 13 is provided not only on the inner side of first electrode 11 (the side closer to fixing body 16) and on the inner side of second electrode 12 (the side closer to fixing body 16), but also on the outer side of first electrode 11 and the outer side of second electrode 12. In addition, insulator 13 is also provided further on the lower side of the inclined surface than first electrode 11 and second electrode 12. Specifically, insulator 13 is also located further on the lower side of the inclined surface than first electrode edge 11S of first electrode 11 and second electrode edge 12S of second electrode 12. The portion of insulator 13 located further on the lower side of the inclined surface than first electrode 11 and second electrode 12 on the inclined surface is auxiliary portion 30. Auxiliary portion 30 is exposed on first mounting surface 1a, and the surface of auxiliary portion 30 is flush with the surface of first electrode 11 and the surface of second electrode 12. By providing such auxiliary portion 30, the design of support 1D can be enhanced. Auxiliary portion 30 may be a resin portion made of a resin material. That is, in the present embodiment, insulator 13 may be made of a resin material.

With support 1D configured as described above, inclined mounting module 100D illustrated in FIG. 23 and FIG. 24 can be obtained by mounting electronic component 2 on first mounting surface 1a of support 1D via solder 3 as in Embodiment 1. Further, a circuit module can be obtained by mounting, on a circuit board, support 1D having electronic component 2 mounted thereon.

At this time, in support 1D according to the present embodiment, as in Embodiment 1, first electrode edge 11S of first electrode 11 and second electrode edge 12S of second electrode 12 serve as alignment references for aligning electronic component 2 when electronic component 2 is mounted on support 1D using solder 3, and are spaced apart from second mounting surface 1b in a direction orthogonal to second mounting surface 1b.

Accordingly, as in support 1 in Embodiment 1, when mounting electronic component 2 on support 1D via solder 3, electronic component 2 placed on solder 3 applied to first electrode 11 and second electrode 12 is automatically aligned. That is, electronic component 2 can be readily aligned without being displaced from its predetermined mounting position on support 1D.

In the present embodiment, first electrode 11, second electrode 12, and fixing body 16 that are metal members are embedded in the resin forming insulator 13. That is, support 1D of the present embodiment is a composite of metal and resin. Accordingly, it is possible to not only readily ensure electrical insulation between first electrode 11 and second electrode 12, but also fabricate support 1D by insert molding. Specifically, first electrode 11, second electrode 12, and fixing body 16, which are metal members, are set in a mold, and resin is injected into the mold and solidified, so that these metal members are embedded and fixed in the resin, allowing support 1D to be fabricated. Accordingly, since support 1D can be formed using members that are inexpensive and easy to process, support 1D can not only be manufactured at low cost, but can also exhibit excellent shape control.

### [Embodiment 3]

Next, support 1E according to Embodiment 3 will be described with reference to FIG. 25. FIG. 25 is a perspective view of support 1E according to Embodiment 3.

As illustrated in FIG. 25, support 1E according to the present embodiment includes first mounting surface 1a and second mounting surface 1b as in Embodiment 1. As in Embodiment 1, support 1E includes first electrode 11, second electrode 12, insulator 13, first protector 14, and second protector 15. Support 1E is configured such that insulator 13 of support 1 according to Embodiment 1 is divided into first insulator 13a and second insulator 13b and that fixing body 16 is further included.

Since support 1E includes fixing body 16, mechanical strength of support 1E against vibration can be readily ensured as in Embodiment 2. In addition, since fixing body 16 also serves as a heat-dissipating body, fixing body 16 has the function of dissipating heat generated by electronic component 2 (not illustrated) mounted on support 1E. In the present embodiment, fixing body 16 is disposed between first insulator 13a and second insulator 13b. First insulator 13a is disposed between fixing body 16 and first electrode 11. Second insulator 13b is disposed between fixing body 16 and second electrode 12.

Not only first electrode 11, second electrode 12, insulator 13 (first insulator 13a, second insulator 13b), first protector 14, and second protector 15 but also fixing body 16 are exposed on each of first mounting surface 1a and second mounting surface 1b of support 1E. Therefore, heat generated by electronic component 2 (not illustrated) mounted on first mounting surface 1a is conducted from first mounting surface 1a to second mounting surface 1b not only via first electrode 11 and second electrode 12 but also via fixing body 16. Accordingly, heat generated by electronic component 2 mounted on first mounting surface 1a can be efficiently dissipated.

When support 1E is viewed from a side (Y-axis direction), projection views (side views) of first electrode 11 and second electrode 12 are the same in shape. Accordingly, first electrode 11 and second electrode 12 can each be fabricated by performing punching processing on a metal plate. Thus, it is possible to implement support 1E having excellent industrial producibility. Note that, in the present embodiment, first electrode 11 and second electrode 12 are the same in shape and size.

Further, as in Embodiment 1, first protector 14 covers a side surface of first electrode 11, and second protector 15 covers a side surface of second electrode 12. Note that first protector 14 and second protector 15 according to the present embodiment are thicker than first protector 14 and second protector 15 according to Embodiment 1.

Note that, in the present embodiment, first insulator 13a, second insulator 13b, first protector 14, and second protector 15 are not integrally configured. That is, first electrode 11, second electrode 12, first insulator 13a, second insulator 13b, first protector 14, second protector 15, and fixing body 16 are each a separate, flat plate-shaped member and constitute a layered structure. Note that these members are bonded to one another.

With this configuration, sufficient electrical insulation can be ensured between first electrode 11 and second electrode 12; therefore, support 1E having electrical reliability can be obtained. Moreover, since first electrode 11 and second electrode 12 have height and thickness, first electrode 11 and second electrode 12 have a large envelope volume. Accordingly, heat generated by electronic component 2 mounted on first mounting surface 1a of support 1E can be efficiently transmitted to second mounting surface 1b and further to the circuit board.

Note that at least one selected from first electrode 11, second electrode 12, and fixing body 16 may have a multilayer structure. This allows support 1E to be a structure that includes a plurality of thin metal plates; therefore, support 1E becomes suitable for punching process. For example, in FIG. 25, the following structure can be considered: second electrode 12 is divided into two so that second electrode 12 is constituted by two metal plates; insulator 13 is constituted by first insulator 13a, second insulator 13b, and a third insulator; and the third insulator is sandwiched between the two divided second electrodes 12.

With support 1E configured as described above, an inclined mounting module can be obtained by mounting electronic component 2 on first mounting surface 1a of support 1E as in Embodiment 1. Further, a circuit module can be obtained by mounting, on a circuit board, support 1E having electronic component 2 mounted thereon.

At this time, in support 1E according to the present embodiment, as in Embodiment 1, first electrode edge 11S of first electrode 11 and second electrode edge 12S of second electrode 12 serve as alignment references for aligning electronic component 2 when electronic component 2 is mounted on support 1E using solder 3, and are spaced apart from second mounting surface 1b in a direction orthogonal to second mounting surface 1b.

Accordingly, as in support 1 in Embodiment 1, when mounting electronic component 2 on support 1E via solder 3, electronic component 2 placed on solder 3 applied to first electrode 11 and second electrode 12 is automatically aligned. That is, electronic component 2 can be readily aligned without being displaced from its predetermined mounting position on support 1E.

When electronic component 2 was actually mounted using support 1E according to the present embodiment, it was possible to obtain inclined mounting module 100E illustrated in FIG. 26. FIG. 26 is an optical photograph showing a side view of inclined mounting module 100E that was actually fabricated. As illustrated in FIG. 26, it can be seen that electronic component 2 was able to be mounted at its predetermined mounting position on first mounting surface 1a of support 1E.

Note that when electronic component 2 was actually mounted using support 1E' that is greater than support 1E in height as illustrated in FIG. 27 to manufacture inclined mounting module 100E', it was still possible, as illustrated in FIG. 28, to mount electronic component 2 at its predetermined mounting position on first mounting surface 1a of support 1E'.

### [Embodiment 4]

Next, support 1F according to Embodiment 4 will be described with reference to FIG. 29. FIG. 29 is a perspective view of support 1F according to Embodiment 4.

As illustrated in FIG. 29, support 1F according to the present embodiment includes first mounting surface 1a and second mounting surface 1b as in Embodiment 1. As in Embodiment 3, support 1F includes first electrode 11, second electrode 12, insulator 13 (first insulator 13a and second insulator 13b), first protector 14, second protector 15, and fixing body 16.

The supports according to Embodiments 1 through 3 each include only one first mounting surface 1a; however, support 1F according to the present embodiment includes a plurality of first mounting surfaces 1a. Accordingly, a plurality of electronic components 2 can be readily mounted on support 1F. In the present embodiment, support 1F includes two first mounting surfaces 1a. Two first mounting surfaces 1a are provided on different surfaces and are provided at positions facing away from each other. Note that inclination angles θ of two first mounting surfaces 1a are the same in the present embodiment; however, they may be different.

With support 1F configured as described above, an inclined mounting module can be obtained by mounting electronic component 2 on first mounting surface 1a of support 1F as in Embodiment 1. Further, a circuit module can be obtained by mounting, on a circuit board, support 1F having electronic component 2 mounted thereon.

At this time, in support 1F according to the present embodiment, as in Embodiment 1, first electrode edge 11S of first electrode 11 and second electrode edge 12S of second electrode 12 serve as alignment references for aligning electronic component 2 when electronic component 2 is mounted on support 1F using solder 3, and are spaced apart from second mounting surface 1b in a direction orthogonal to second mounting surface 1b.

Accordingly, as in support 1 in Embodiment 1, when mounting electronic component 2 on support 1F via solder 3, electronic component 2 placed on solder 3 applied to first electrode 11 and second electrode 12 is automatically aligned. That is, electronic component 2 can be readily aligned without being displaced from its predetermined mounting position on support 1F.

When electronic component 2 was actually mounted using support 1F according to the present embodiment, it was possible to obtain inclined mounting module 100F illustrated in FIG. 30. FIG. 30 is an optical photograph showing a side view of inclined mounting module 100F that was actually fabricated. As illustrated in FIG. 30, it can be seen that electronic component 2 was able to be mounted at its predetermined mounting position on first mounting surface 1a of support 1F.

Note that, in FIG. 30, electronic component 2 was mounted only on one of two first mounting surfaces 1a; however, the present disclosure is not limited thereto. That is, electronic component 2 may be mounted on both of two first mounting surfaces 1a.

In the present embodiment, vectors parallel to the respective first mounting surfaces 1a are not directed in one direction (in FIG. 29, they are directed in opposite directions by 180 degrees), but are not limited thereto. For example, vectors parallel to the respective first mounting surfaces 1a may be directed in one direction. That is the case where a plurality of first mounting surfaces 1a having different inclination angles are formed on one surface on one side of the support. In this case, the plurality of first mounting surfaces 1a may be arranged separately in the longitudinal direction (upper and lower sides) or the transverse direction (left and right sides) to face one direction.

### [Embodiment 5]

Next, support 1G according to Embodiment 5 will be described with reference to FIG. 31. FIG. 31 is a perspective view of support 1G according to Embodiment 5.

As illustrated in FIG. 31, support 1G according to the present embodiment includes first mounting surface 1a and second mounting surface 1b as in Embodiment 1. As in Embodiment 3, support 1G includes first electrode 11, second electrode 12, insulator 13 (first insulator 13a and second insulator 13b), first protector 14, second protector 15, and fixing body 16.

Support 1G according to the present embodiment further includes receiving portion 40. Receiving portion 40 includes receiving surface 40a capable of receiving a surface of electronic component 2 different from the mounting surface of electronic component 2 (the surface to be bonded to first mounting surface 1a). When the mounting surface of electronic component 2 is the rear surface of the electronic component, receiving surface 40a of receiving portion 40 is capable of receiving a side surface of electronic component 2. Receiving portion 40 is a protruding portion protruding from an end portion of support 1G on the lower side of the inclined surface. Receiving portion 40 protrudes from a plane including first mounting surface 1a.

Groove 50 is provided in support 1G according to the present embodiment. Groove 50 is formed at the boundary between first mounting surface 1a and receiving portion 40. Specifically, groove 50 is formed at the lower end of first mounting surface 1a. Groove 50 is formed to extend in the Y-axis direction. Specifically, groove 50 is formed so as to penetrate support 1G in the Y-axis direction.

With support 1G configured as described above, an inclined mounting module can be obtained by mounting electronic component 2 on first mounting surface 1a of support 1G as in Embodiment 1. Further, a circuit module can be obtained by mounting, on a circuit board, support 1G having electronic component 2 mounted thereon.

At this time, in support 1G according to the present embodiment, as in Embodiment 1, first electrode edge 11S of first electrode 11 and second electrode edge 12S of second electrode 12 serve as alignment references for aligning electronic component 2 when electronic component 2 is mounted on support 1G using solder 3, and are spaced apart from second mounting surface 1b in a direction orthogonal to second mounting surface 1b.

Accordingly, as in support 1 in Embodiment 1, when mounting electronic component 2 on support 1G via solder 3, electronic component 2 placed on solder 3 applied to first electrode 11 and second electrode 12 is automatically aligned. That is, electronic component 2 can be readily aligned without being displaced from its predetermined mounting position on support 1G.

Further, support 1G according to the present embodiment includes receiving portion 40 capable of receiving electronic component 2.

With this configuration, receiving portion 40 is capable of receiving a side surface of electronic component 2 even if electronic component 2 significantly slides down along the inclination of first mounting surface 1a when support 1G having electronic component 2 placed on solder 3 applied to first mounting surface 1a is introduced into a reflow apparatus and solder 3 is thereby melted. That is, it is possible to prevent electronic component 2 from falling off first mounting surface 1a. At this time, receiving portion 40 may receive the entire side surface of electronic component 2 or may receive part of the side surface of electronic component 2. In this case, receiving surface 40a of receiving portion 40 is a side wall surface of the protruding portion. Note that electronic component 2 need not abut receiving portion 40 during reflow. Even if electronic component 2 abuts receiving portion 40 during reflow, the action of molten solder 3 tending to reduce its volume as much as possible causes electronic component 2 to slide up along the inclination of first mounting surface 1a and be mounted at its predetermined mounting position on support 1G.

In the present embodiment, the shortest distance between receiving portion 40 and one of first electrode 11 or second electrode 12 may be less than one-third of the maximum length of first mounting surface 1a in the inclination direction of first mounting surface 1a that is inclined relative to second mounting surface 1b.

With this configuration, when solder 3 melts and electronic component 2 slides down along the inclination of first mounting surface 1a, receiving portion 40 can reliably prevent movement of electronic component 2. Accordingly, it is possible to improve the accuracy in alignment of electronic component 2 at its predetermined mounting position.

In support 1G according to the present embodiment, groove 50 is provided at the boundary between first mounting surface 1a and receiving portion 40.

This configuration allows formation of first electrode edge 11S and second electrode edge 12S serving as alignment references, and electronic component 2 is thereby mounted at its predetermined mounting position on support 1G.

When electronic component 2 was actually mounted using support 1G according to the present embodiment, it was possible to obtain inclined mounting module 100G illustrated in FIG. 32. FIG. 32 is an optical photograph showing a side view of inclined mounting module 100G that was actually fabricated. As illustrated in FIG. 32, it can be seen that electronic component 2 was able to be mounted at its predetermined mounting position on first mounting surface 1a of support 1G.

### [Embodiment 6]

Next, support 1H according to Embodiment 6 will be described with reference to FIG. 33. FIG. 33 is a perspective view of support 1H according to Embodiment 6.

As illustrated in FIG. 33, support 1H according to the present embodiment includes first mounting surface 1a, second mounting surface 1b, first electrode 11, and second electrode 12 as in support 1 according to Embodiment 1, but unlike support 1 according to Embodiment 1, support 1H according to the present embodiment does not include first protector 14 or second protector 15. Also, unlike Embodiments 2 through 5, support 1H according to the present embodiment does not include fixing body 16. That is, support 1H according to the present embodiment is mainly made of metal.

In the present embodiment, first electrode 11 and second electrode 12 are bent metal plates. First electrode 11 and second electrode 12 can each be fabricated by bending an elongated metal plate. First electrode 11 and second electrode 12 are each bent so as to include an inclined surface serving as first mounting surface 1a and a bottom surface serving as second mounting surface 1b. Note that first mounting surface 1a is constituted only by a surface of first electrode 11 and a surface of second electrode 12. Likewise, second mounting surface 1b is constituted only by a surface of first electrode 11 and a surface of second electrode 12.

First electrode 11 and second electrode 12 can be readily fabricated by typical sheet-metal processing. Therefore, it is possible to obtain support 1H that has excellent industrial producibility and facilitates heat dissipation design. As one example, first electrode 11 and second electrode 12 can each be fabricated by bending a copper plate (1 mm thick, 3 mm wide, 19 mm long) by a machine tool or by hand. First electrode 11 and second electrode 12 of support 1H are the same in shape and size. Note that electrodes (first electrode 11 and second electrode 12) having the bent shape illustrated in FIG. 33 can be formed also by punching out, in the Y direction, metal plates having a thickness.

First electrode 11 and second electrode 12 are spaced apart from each other by a gap (air layer). Specifically, first electrode 11 and second electrode 12 are disposed in parallel with a gap therebetween such that first mounting surface 1a of first electrode 11 and first mounting surface 1a of second electrode 12 lie in a single plane and that second mounting surface 1b of first electrode 11 and second mounting surface 1b of second electrode 12 lie in a single plane.

In the present embodiment, first electrode 11 and second electrode 12 are fixed to resin member 17 having an electrically insulating property. Accordingly, first electrode 11 and second electrode 12 can be integrated via resin member 17. Resin member 17 functions as a holding member that maintains a gap between first electrode 11 and second electrode 12. First electrode 11 and second electrode 12 are part of a molded article in which first electrode 11 and second electrode 12 are at least partially embedded in resin member 17. Resin member 17 is a resin block made of an electrically insulating resin material.

With support 1H configured as described above, an inclined mounting module can be obtained by mounting electronic component 2 on first mounting surface 1a of support 1H as in Embodiment 1. Further, a circuit module can be obtained by mounting, on a circuit board, support 1H having electronic component 2 mounted thereon.

At this time, in support 1H according to the present embodiment, as in Embodiment 1, first electrode edge 11S of first electrode 11 and second electrode edge 12S of second electrode 12 serve as alignment references for aligning electronic component 2 when electronic component 2 is mounted on support 1H using solder 3, and are spaced apart from second mounting surface 1b in a direction orthogonal to second mounting surface 1b.

Accordingly, as in support 1 in Embodiment 1, when mounting electronic component 2 on support 1H via solder 3, electronic component 2 placed on solder 3 applied to first electrode 11 and second electrode 12 is automatically aligned. That is, electronic component 2 can be readily aligned without being displaced from its predetermined mounting position on support 1H.

When electronic component 2 was actually mounted using support 1H according to the present embodiment, it was possible to obtain inclined mounting module 100H illustrated in FIG. 34. FIG. 34 is an optical photograph showing a side view of inclined mounting module 100H that was actually fabricated. As illustrated in FIG. 34, it can be seen that electronic component 2 was able to be mounted at its predetermined mounting position on first mounting surface 1a of support 1H.

When electronic component 2 was actually mounted using support 1H' that is greater than support 1H in inclination angle of first mounting surface 1a as illustrated in FIG. 35 to manufacture inclined mounting module 100H', it was still possible, as illustrated in FIG. 35, to mount electronic component 2 at its predetermined mounting position on first mounting surface 1a of support 1H'. In this case, traces of molten solder adhering to an electrode of electronic component 2 as a result of electronic component 2 abutting the surface of resin member 17 were observed. That is, it is considered that when solder 3 melted during reflow, electronic component 2 temporarily slid down along first mounting surface 1a and abutted first electrode 11 and second electrode 12, and thereafter slid up along first mounting surface 1a when the volume of solder 3 decreased.

### [Embodiment 7]

Next, support 1I according to Embodiment 7 will be described with reference to FIG. 36. FIG. 36 is a perspective view of support 1I according to Embodiment 7.

As illustrated in FIG. 36, support 1I according to the present embodiment includes first mounting surface 1a and second mounting surface 1b as in support 1 according to Embodiment 1. As in Embodiment 6, support 1I according to the present embodiment does not include first protector 14, second protector 15, or fixing body 16.

Support 1I according to the present embodiment has the structure according to Embodiment 6 except that resin member 17 is not included. That is, support 1I includes first electrode 11 and second electrode 12 only. That is to say, support 1I is made of metal only. Specifically, in the present embodiment, first electrode 11 and second electrode 12 are bent metal plates as in Embodiment 6. First electrode 11 and second electrode 12 can each be fabricated by bending an elongated metal plate. Thus, since support 1I can be formed by metal processing only, support 1I can be fabricated at low cost. Note that first electrode 11 and second electrode 12 according to the present embodiment are the same as first electrode 11 and second electrode 12 according to Embodiment 6.

With support 1I configured as described above, an inclined mounting module can be obtained by mounting electronic component 2 on first mounting surface 1a of support 1I. Further, a circuit module can be obtained by mounting, on a circuit board, support 1I having electronic component 2 mounted thereon.

At this time, in support 1I according to the present embodiment, as in Embodiment 1, first electrode edge 11S of first electrode 11 and second electrode edge 12S of second electrode 12 serve as alignment references for aligning electronic component 2 when electronic component 2 is mounted on support 1I using solder 3, and are spaced apart from second mounting surface 1b in a direction orthogonal to second mounting surface 1b.

Accordingly, as in support 1 in Embodiment 1, when mounting electronic component 2 on support 1I via solder 3, electronic component 2 placed on solder 3 applied to first electrode 11 and second electrode 12 is automatically aligned. That is, electronic component 2 can be readily aligned without being displaced from its predetermined mounting position on support 1I.

Note that since first electrode 11 and second electrode 12 in the present embodiment are not fixed by resin member 17, a circuit module can be fabricated by: bonding first electrode 11 and second electrode 12 to a circuit board using solder with a predetermined gap therebetween; and mounting electronic component 2 on support 1I that is constituted by this pair of first electrode 11 and second electrode 12.

Further, as in support 1I' illustrated in FIG. 37, the support may include first electrode 11 and second electrode 12 that are greater in thickness than first electrode 11 and second electrode 12 of support 1I illustrated in FIG. 36.

Furthermore, the support may be support 1J that includes first electrode 11 and second electrode 12 having the shape illustrated in FIG. 38. In support 1J illustrated in FIG. 38, stoppers are formed on the lower side of first mounting surfaces 1a by bending metal plates constituting first electrode 11 and second electrode 12.

### [Embodiment 8]

Next, support 1K according to Embodiment 8 will be described with reference to FIG. 39. FIG. 39 is a perspective view of support 1K according to Embodiment 8.

As illustrated in FIG. 39, support 1K according to the present embodiment includes first mounting surface 1a and second mounting surface 1b as in Embodiment 1. As in Embodiment 3, support 1K includes first electrode 11, second electrode 12, insulator 13 (first insulator 13a and second insulator 13b), first protector 14, second protector 15, and fixing body 16.

As in Embodiment 5, support 1K according to the present embodiment includes receiving portion 40. Receiving portion 40 includes receiving surface 40a capable of receiving a surface of an electronic component different from the mounting surface of the electronic component (the surface to be bonded to first mounting surface 1a). When the mounting surface of the electronic component is the rear surface of the electronic component, receiving surface 40a of receiving portion 40 receives a side surface of electronic component 2. In the present embodiment as well, receiving portion 40 is a protruding portion protruding from an end portion of support 1K on the lower side of inclined surface 1a.

As in support 1G according to Embodiment 5, groove 50 is provided in support 1K according to the present embodiment. Groove 50 is formed at the boundary between first mounting surface 1a and receiving portion 40. Specifically, groove 50 is formed at the lower end of first mounting surface 1a. Groove 50 is formed to extend in the Y-axis direction. Specifically, groove 50 is formed so as to penetrate support 1K in the Y-axis direction.

Unlike support 1 according to Embodiment 1, the angle between first mounting surface 1a and second mounting surface 1b in support 1K according to the present embodiment is 90 degrees. That is, in Embodiment 1, inclination angle θ of first mounting surface 1a relative to second mounting surface 1b satisfies 0 degrees < θ < 90 degrees, whereas in support 1K according to the present embodiment, inclination angle θ of first mounting surface 1a relative to second mounting surface 1b is θ = 90 degrees.

With support 1K configured as described above, an inclined mounting module can be obtained by mounting electronic component 2 on first mounting surface 1a of support 1K as in Embodiment 1. That is, even when the angle between first mounting surface 1a and second mounting surface 1b (inclination angle) is 90 degrees, an inclined mounting module having electronic component 2 mounted at its predetermined position can be obtained. The inclined mounting module obtained in this manner is a perpendicular mounting module in which first mounting surface 1a and second mounting surface 1b are perpendicular to each other. Further, a circuit module can be obtained by mounting, on a circuit board, support 1K having electronic component 2 mounted thereon.

At this time, in support 1K according to the present embodiment, as in Embodiment 1, first electrode edge 11S of first electrode 11 and second electrode edge 12S of second electrode 12 serve as alignment references for aligning electronic component 2 when electronic component 2 is mounted on support 1K using solder 3. First electrode edge 11S and second electrode edge 12S are spaced apart from second mounting surface 1b in a direction orthogonal to second mounting surface 1b.

Accordingly, as in support 1 in Embodiment 1, when mounting electronic component 2 on support 1K via solder 3, electronic component 2 placed on solder 3 applied to first electrode 11 and second electrode 12 is automatically aligned. That is, electronic component 2 can be readily aligned without being displaced from its predetermined mounting position on support 1K.

Further, support 1K according to the present embodiment includes receiving portion 40 capable of receiving electronic component 2.

With this configuration, receiving portion 40 is capable of receiving a side surface of electronic component 2 even if electronic component 2 significantly slides down in the negative Z direction along first mounting surface 1a when support 1K having electronic component 2 adhered to cream solder 3 applied to first mounting surface 1a is introduced into a reflow apparatus and solder 3 is thereby melted. That is, it is possible to prevent electronic component 2 from falling off first mounting surface 1a. At this time, receiving portion 40 may receive the entire side surface of electronic component 2 or may receive part of the side surface of electronic component 2. In this case, receiving surface 40a of receiving portion 40 is a side wall surface of the protruding portion. Note that electronic component 2 need not abut receiving portion 40 during reflow. Even if electronic component 2 abuts receiving portion 40 during reflow, the action of molten solder 3 tending to reduce its volume as much as possible causes electronic component 2 to slide up along the inclination of first mounting surface 1a and be mounted at its predetermined mounting position on support 1K, that is, electronic component 2 is mounted at its predetermined position on first mounting surface 1a that is perpendicular to second mounting surface 1b.

In the present embodiment, the shortest distance between receiving portion 40 and one of first electrode 11 or second electrode 12 may be less than one-third of the maximum length of first mounting surface 1a in the inclination direction of first mounting surface 1a that is inclined to be perpendicular to second mounting surface 1b.

With this configuration, when solder 3 melts and electronic component 2 slides down in the negative Z direction along first mounting surface 1a, receiving portion 40 can reliably prevent movement of electronic component 2. Accordingly, it is possible to improve the accuracy in alignment of electronic component 2 at its predetermined mounting position.

In support 1K according to the present embodiment, groove 50 is provided at the boundary between first mounting surface 1a and receiving portion 40.

This configuration allows formation of first electrode edge 11S and second electrode edge 12S serving as alignment references, and electronic component 2 is thereby mounted at its predetermined mounting position on support 1K.

When electronic component 2 was actually mounted using support 1K according to the present embodiment, it was possible to obtain inclined mounting module 100K (perpendicular mounting module) illustrated in FIG. 40. FIG. 40 is an optical photograph showing a side view of inclined mounting module 100K that was actually fabricated. As illustrated in FIG. 40, it can be seen that electronic component 2 was able to be mounted on first mounting surface 1a located directly above groove 50 provided in support 1K.

### [Embodiment 9]

Next, support 1L according to Embodiment 9 will be described with reference to FIG. 41. FIG. 41 is a perspective view of support 1L according to Embodiment 9.

As illustrated in FIG. 41, support 1L according to the present embodiment includes first mounting surface 1a and second mounting surface 1b as in Embodiment 1. As in Embodiment 1, support 1L includes first electrode 11, second electrode 12, and insulator 13.

Support 1L according to the present embodiment and support 1 according to Embodiment 1 differ in the extending direction of first electrode 11 and second electrode 12 on first mounting surface 1a. Specifically, on first mounting surface 1a, first electrode 11 and second electrode 12 in Embodiment 1 extend in the inclination direction of first mounting surface 1a, whereas first electrode 11 and second electrode 12 in the present embodiment extend in a direction intersecting the inclination direction of first mounting surface 1a. That is, first electrode 11 and second electrode 12 exposed on each of first mounting surface 1a and second mounting surface 1b are each disposed to extend across each of first mounting surface 1a and second mounting surface 1b. In other words, on first mounting surface 1a, first electrode 11 and second electrode 12 extend in the Y-axis direction. Note that first electrode 11 and second electrode 12 are spaced apart from second mounting surface 1b in a direction orthogonal to second mounting surface 1b.

In support 1L according to the present embodiment, insulator 13 is divided into first insulator 13a, second insulator 13b, and third insulator 13c. First electrode 11 is disposed between first insulator 13a and second insulator 13b, and second electrode 12 is disposed between second insulator 13b and third insulator 13c. Specifically, first insulator 13a is disposed to be in contact with first electrode 11 only. Second insulator 13b is disposed to be in contact with each of first electrode 11 and second electrode 12. Third insulator 13c is disposed to be in contact with second electrode 12 only.

Note that when support 1L is viewed from a side (Y-axis direction), projection views (side views) of first electrode 11 and second electrode 12 are different from each other in shape and size.

First electrode 11, second electrode 12, and insulator 13 (first insulator 13a, second insulator 13b, third insulator 13c) are exposed on each of first mounting surface 1a and second mounting surface 1b of support 1L. Therefore, heat generated by electronic component 2 (not illustrated) mounted on first mounting surface 1a is conducted from first mounting surface 1a to second mounting surface 1b via first electrode 11 and second electrode 12. Accordingly, heat generated by electronic component 2 mounted on first mounting surface 1a can be efficiently dissipated.

Note that support 1L according to the present embodiment may include first protector 14 and/or second protector 15 as in Embodiment 1. That is, the side surfaces of both first electrode 11 and second electrode 12 may be covered by first protector 14 and/or second protector 15.

In FIG. 41, first insulator 13a, second insulator 13b, and third insulator 13c are not integrally formed, but the present disclosure is not limited thereto. For example, first insulator 13a, second insulator 13b, and third insulator 13c may form an integrally molded article in which at least two of them are integrally formed, or may form an integrally molded article in which all of them are integrally formed.

In FIG. 41, the shape of each of first electrode 11 and second electrode 12 is a flat plate in the form of a trapezoidal prism, but the present disclosure is not limited thereto. For example, the shapes of first electrode 11 and second electrode 12 may be such that the shape of at least one of them is a flat plate having a missing portion in which an insulator is provided, and the insulators in contact with the missing portion are connected to each other to form an integrated structure. With this configuration, sufficient electrical insulation can be ensured between first electrode 11 and second electrode 12; therefore, support 1L having electrical reliability can be obtained. Moreover, since first electrode 11 and second electrode 12 have height and thickness, they have a large envelope volume. Accordingly, heat generated by electronic component 2 mounted on first mounting surface 1a of support 1L can be efficiently transmitted to second mounting surface 1b and further to the circuit board.

With support 1L configured as described above, an inclined mounting module can be obtained by mounting electronic component 2 on first mounting surface 1a of support 1L as in Embodiment 1. Further, a circuit module can be obtained by mounting, on a circuit board, support 1L having electronic component 2 mounted thereon.

At this time, in support 1L according to the present embodiment, as in Embodiment 1, at least one of first electrode edge 11S of first electrode 11 or second electrode edge 12S of second electrode 12 serves as an alignment reference for aligning electronic component 2 when electronic component 2 is mounted on support 1L using solder 3. Specifically, in the present embodiment, second electrode 12 is located lower than first electrode 11 on first mounting surface 1a; therefore, second electrode edge 12S, that is the lower electrode edge of second electrode 12, serves as an alignment reference. First electrode edge 11S and second electrode edge 12S are spaced apart from second mounting surface 1b in a direction orthogonal to second mounting surface 1b.

Accordingly, as in support 1 in Embodiment 1, when mounting electronic component 2 on support 1L via solder 3, electronic component 2 placed on solder 3 applied to first electrode 11 and second electrode 12 is automatically aligned. That is, electronic component 2 can be readily aligned without being displaced from its predetermined mounting position on support 1L. Note that, instead of using either first electrode edge 11S or second electrode edge 12S as an alignment reference, both of first electrode edge 11S and second electrode edge 12S may be used as alignment references.

### [Embodiment 10]

Next, support 1M and inclined mounting module 100M according to Embodiment 10 will be described with reference to FIG. 42 and FIG. 43. FIG. 42 is a perspective view of support 1M according to Embodiment 10. FIG. 43 is a perspective view of inclined mounting module 100M according to Embodiment 10.

As illustrated in FIG. 42, support 1M according to the present embodiment includes first mounting surface 1a and second mounting surface 1b as in support 1 according to Embodiment 1. As in support 1I according to Embodiment 7, support 1M according to the present embodiment does not include first protector 14, second protector 15, or fixing body 16, and includes first electrode 11 and second electrode 12 only.

First electrode 11 and second electrode 12 in the present embodiment are bent metal plates as in Embodiment 7. First electrode 11 and second electrode 12 can each be fabricated by bending an elongated metal plate. First electrode 11 and second electrode 12 are each bent so as to include an inclined surface serving as first mounting surface 1a and a bottom surface serving as second mounting surface 1b.

Specifically, each of first electrode 11 and second electrode 12 is formed by bending a single elongated metal plate into a V shape. That is, in each of first electrode 11 and second electrode 12, the metal plate has only one bent portion. Accordingly, the bending process can be completed in a single operation, and the amount (length) of the metal plates used as the electrodes can be minimized, thus reducing manufacturing cost.

First electrode 11 formed in a V shape includes: first metal plate 11a that is elongated and includes first mounting surface 1a; and second metal plate 11b that is elongated and includes second mounting surface 1b. Likewise, second electrode 12 formed in a V shape includes: first metal plate 12a that is elongated and includes first mounting surface 1a; and second metal plate 12b that is elongated and includes second mounting surface 1b.

As illustrated in FIG. 42, first notch portion 11a1 is formed in first metal plate 11a of first electrode 11. First notch portion 11a1 is formed so as to cut out a side of first metal plate 11a. Specifically, first notch portion 11a1 is formed in a portion of first metal plate 11a facing first metal plate 12a of second electrode 12. First notch portion 11a1 extends in a direction orthogonal to the longitudinal direction of first metal plate 11a. In the present embodiment, first notch portion 11a1 extends in the Y-axis direction. First notch portion 11a1 cuts out, for example, at least half of first metal plate 11a in the width direction. First notch portion 11a1 is, for example, located higher than the central portion of first metal plate 11a in the longitudinal direction; however, the present disclosure is not limited thereto.

Further, second notch portion 12a1 is formed in first metal plate 12a of second electrode 12. Second notch portion 12a1 is formed so as to cut out a side of first metal place 12a. Specifically, second notch portion 12a1 is formed in a portion of first metal plate 12a facing first metal plate 11a of first electrode 11. In the present embodiment, second notch portion 12a1 faces first notch portion 11a1. That is, first notch portion 11a1 and second notch portion 12a1 are located on a straight line with a gap therebetween. Second notch portion 12a1 extends in a direction orthogonal to the longitudinal direction of first metal plate 12a. In the present embodiment, second notch portion 12a1 extends in the Y-axis direction. Second notch portion 12a1 cuts out, for example, at least half of first metal plate 12a in the width direction. Second notch portion 12a1 is, for example, located higher than the central portion of first metal plate 12a in the longitudinal direction; however, the present disclosure is not limited thereto.

First mounting surface 1a is constituted only by a surface of first electrode 11 and a surface of second electrode 12. Specifically, in first electrode 11, first mounting surface 1a is a portion located higher than first notch portion 11a1, and in second electrode 12, first mounting surface 1a is a portion located higher than second notch portion 12a1. That is, the portion of the surface of first metal plate 11a of first electrode 11 that is located higher than first notch portion 11a1, and the portion of the surface of first metal plate 12a of second electrode 12 that is located higher than second notch portion 12a1, are each first mounting surface 1a on which electronic component 2 is mounted.

Note that the portion of the surface of first metal plate 11a of first electrode 11 that is located lower than first notch portion 11a1, and the portion of the surface of first metal plate 12a of second electrode 12 that is located lower than second notch portion 12a1, are each non-mounting surface 1c on which electronic component 2 is not mounted.

Second mounting surface 1b is also constituted only by a surface of first electrode 11 and a surface of second electrode 12. Specifically, second mounting surface 1b is a surface combining the entire lower surface of second metal plate 11b of first electrode 11 and the entire lower surface of second metal plate 12b of second electrode 12.

Note that, in the present embodiment, first electrode edge 11S is not an end of first electrode 11, but an edge of first notch portion 11a1. Likewise, second electrode edge 12S is not an end of second electrode 12, but an edge of second notch portion 12a1. Specifically, first electrode edge 11S is the upper edge of first notch portion 11a1, and second electrode edge 12S is the upper edge of second notch portion 12a1.

With support 1M configured as described above, inclined mounting module 100M illustrated in FIG. 43 can be obtained by mounting electronic component 2 on first mounting surface 1a of support 1M via solder 3 as in Embodiment 1. Further, a circuit module can be obtained by mounting, on a circuit board, support 1M having electronic component 2 mounted thereon. Note that, in the present embodiment as well, electronic component 2 is a surface-mount white LED package, but does not include a lens.

At this time, in support 1M according to the present embodiment, as in Embodiment 1, first electrode edge 11S and second electrode edge 12S exposed on first mounting surface 1a serve as alignment references for aligning electronic component 2 when electronic component 2 is mounted on support 1M using solder 3. Further, first electrode edge 11S and second electrode edge 12S are spaced apart from second mounting surface 1b in a direction orthogonal to second mounting surface 1b.

Accordingly, as in support 1 in Embodiment 1, when mounting electronic component 2 on support 1M via solder 3, electronic component 2 placed on solder 3 applied to first electrode 11 and second electrode 12 is automatically aligned. That is, electronic component 2 can be readily aligned without being displaced from its predetermined mounting position on support 1M.

Note that, in the present embodiment as well, first electrode 11 and second electrode 12 are not fixed by resin member 17, and thus, a circuit module can be fabricated by: bonding first electrode 11 and second electrode 12 to a circuit board using solder with a predetermined gap therebetween; and mounting electronic component 2 on support 1M that is constituted by this pair of first electrode 11 and second electrode 12.

Therefore, heat generated by electronic component 2 mounted on first mounting surface 1a is conducted from first mounting surface 1a to second mounting surface 1b via first electrode 11 and second electrode 12. Accordingly, heat generated by electronic component 2 mounted on first mounting surface 1a can be efficiently dissipated.

Note that, in the present embodiment, first notch portion 11a1 of first electrode 11 and second notch portion 12a1 of second electrode 12 are each formed in the shape of a slit; however, the present disclosure is not limited thereto. For example, as in support 1M' illustrated in FIG. 44, first notch portion 11a1 may be formed so as to cut out the entire lower portion of first metal plate 11a of first electrode 11. Likewise, second notch portion 12a1 may be formed so as to cut out the entire lower portion of first metal plate 12a of second electrode 12.

In the present embodiment, each of first electrode 11 and second electrode 12 is formed by bending a single elongated metal plate into a V shape; however, the present disclosure is not limited thereto. For example, as in support 1N illustrated in FIG. 45, each of first electrode 11 and second electrode 12 may be formed by bending a single elongated metal plate into an L shape. In this case, first mounting surface 1a and second mounting surface 1b are perpendicular to each other. That is, the angle (inclination angle) between first mounting surface 1a and second mounting surface 1b is 90 degrees. Therefore, an inclined mounting module obtained by mounting electronic component 2 on support 1N illustrated in FIG. 45 is a perpendicular mounting module in which first mounting surface 1a and second mounting surface 1b are perpendicular to each other as illustrated in FIG. 46. Note that, in the present variation as well, as in support 1N' illustrated in FIG. 47, first notch portion 11a1 may be formed so as to cut out the entire lower portion of first metal plate 11a of first electrode 11 instead of being formed in the shape of a slit. Likewise, second notch portion 12a1 may also be formed so as to cut out the entire lower portion of first metal plate 12a of second electrode 12 instead of being formed in the shape of a slit.

### [Variations]

Although supports and the like according to the present invention have been described based on Embodiments 1 through 7, the present invention is not limited to Embodiments 1 through 7.

For example, when fabricating support 1E according to Embodiment 3, first electrode 11, second electrode 12, first insulator 13a, second insulator 13b, first protector 14, second protector 15, and fixing body 16 are separately fabricated and then bonded to one another; however, the present disclosure is not limited thereto. For example, support 1E can be fabricated by cutting out part of multilayer substrate 400 illustrated in FIG. 48 and FIG. 49. As illustrated in FIG. 48, multilayer substrate 400 has a layered structure of: metal layer 401; insulating layer 402, metal layer 403, and insulating layer 404 that are sequentially stacked on one surface of metal layer 401; and insulating layer 405, metal layer 406, and insulating layer 407 that are sequentially stacked on the other surface of metal layer 401. Metal layers 401, 403, and 406 are, for example, copper layers and correspond to fixed body 16, first electrode 11, and second electrode 12, respectively. Insulating layers 402, 404, 405, and 407 are, for example, resin layers such as prepreg (a carbon fiber sheet pre-impregnated with resin) or glass-epoxy base materials, and correspond to first insulator 13a, first protector 14, second insulator 13b, and second protector 15, respectively. By performing router machining on multilayer substrate 400 using a router machine, support 1E having the shape illustrated in FIG. 25 can be fabricated. Note that support 1G can also be produced by performing punching processing or the like on multilayer substrate 400 instead of router machining.

Note that, in Embodiment 8, inclination angle θ of first mounting surface 1a relative to second mounting surface 1b is set to θ = 90 degrees. In this case, as in inclined mounting module 100P illustrated in (a) of FIG. 50, support 1P whose inclination angle θ is 90 degrees may be supported by an inclined surface of base member 9. Further, as in inclined mounting module 100P' illustrated in (b) of FIG. 50, when support 1K' is supported by an inclined surface of base member 9', inclination angle θ of first mounting surface 1a of support 1K' may exceed 90 degrees. Thus, inclination angle θ of first mounting surface 1a relative to second mounting surface 1b may be θ ≥ 90 degrees. Note that when mounting electronic component 2 on a support whose inclination angle θ is θ ≥ 90 degrees, electronic component 2 can be readily mounted on first mounting surface 1a by making first mounting surface 1a horizontal through adjustment of the inclination of the support. Further, when fabricating a circuit module in a single flow using a support whose inclination angle θ of first mounting surface 1a is θ ≥ 90 degrees, a circuit board having a tilted base member may be used. Note that base members 9 and 9' have a right-triangular cross-sectional shape, but are not limited thereto.

In Embodiment 1, the electronic devices including an inclined mounting module and a circuit module have been described with reference to electronic device 300 illustrated in FIG. 19 and electronic device 300X illustrated in FIG. 20 as examples; however, the present disclosure is not limited to these forms.

For example, although electronic device 300 (illumination device) illustrated in FIG. 19 includes circuit module 201 illustrated in FIG. 12, the present disclosure is not limited thereto. Specifically, any of the circuit modules or inclined mounting modules illustrated in FIG. 13 through FIG. 18 may be included instead.

Further, electronic device 300X serving as a detection device or an evaluation device may also include any of the circuit modules or inclined mounting modules illustrated in FIG. 12 through FIG. 18. In the case of combining a solid-state light-emitting element and a light detection element, the solid-state light-emitting element and the light detection element may be disposed in a manner that primary light emitted by the solid-state light-emitting element is directly incident on the light-receiving surface of the light detection element, or that the primary light is not directly incident on the light-receiving surface of the light detection element. In the latter case, the light detection element may be configured to detect a light component reflected or diffused by substance 8 when substance 8 is present in front of a light extraction surface of the solid-state light-emitting element. This configuration makes it possible to effectively suppress detection of stray light of the primary light emitted by the solid-state light-emitting element.

Further, in Embodiment 1 and the like, a surface-mount electronic component including a plurality of electrodes on the rear surface is used as electronic component 2. In this case, the electrodes of electronic component 2 have patterns illustrated in FIG. 51, for example. In FIG. 51, (a) illustrates an electrode pattern in which a pair of electrodes, namely a positive electrode and a negative electrode, have the same shape and the same size, (b) illustrates an electrode pattern in which a positive electrode and a negative electrode are different in size (in the diagram, the negative electrode is larger than the positive electrode), and (c) illustrates an electrode pattern in which a heat-dissipating electrode that dissipates heat is added between a positive electrode and a negative electrode.

When using such surface-mount electronic component 2, at least one of the paired electrodes provided on the rear surface of electronic component 2 may be configured such that the shape of the side facing the other electrode is linear, or the shape of the tip of a convex portion of the side facing the other electrode is linear. Similarly, at least one of first electrode 11 or second electrode 12 exposed on first mounting surface 1a may be configured such that, on first mounting surface 1a, the shape of the side facing the other electrode is linear, or the shape of the tip of a convex portion of the side facing the other electrode is linear. In another form, first and second electrodes 11 and 12 and the pair of electrodes of electronic component 2 may both be configured as described above.

By configuring first electrode 11 and second electrode 12 or the pair of electrodes of electronic component 2 in such a manner, solder that melts and solidifies acts to align the linear electrode edge portion of at least one of first electrode 11 or second electrode 12 exposed on first mounting surface 1a with the linear electrode edge portion of an electrode of electronic component 2 that is to be bonded thereto; therefore, an inclined mounting module with small rotational misalignment of electronic component 2 on first mounting surface 1a (inclined surface) can be obtained.

In this case, the linear electrode edge portion of either first electrode 11 or second electrode 12 on first mounting surface 1a may have the same length as the linear electrode edge portion of electronic component 2 that is to be bonded via solder. In another form, the linear electrode edge portions of both first electrode 11 and second electrode 12 may have the same length as the opposing linear electrode edge portions of the paired electrodes of electronic component 2. With such a configuration, solder that melts and solidifies acts to match the length of the linear electrode edge portion of at least one of first electrode 11 or second electrode 12 exposed on first mounting surface 1a with the length of the linear electrode edge portion of an electrode of electronic component 2 that is to be bonded thereto; therefore, misalignment of electronic component 2 on first mounting surface 1a can be reduced in both the rotational direction and the inclination direction. Accordingly, an inclined mounting module suitable for precise control of the mounting position can be obtained. Note that, by making the electrode spacing between first electrode 11 and second electrode 12 on first mounting surface 1a equal to the electrode spacing between the paired electrodes on the rear surface of electronic component 2, misalignment of electronic component 2 can be further reduced.

According to the present invention, "inclined mounting module" is a concept that includes a perpendicular mounting module such as the one described in Embodiment 8; however, "inclined mounting module" may be a concept that does not include a perpendicular mounting module.

Note that the concept of electronic devices according to the present invention broadly includes electronic device systems. For example, the electronic devices according to the present invention also include electronic device systems in which various types of software including machine learning, or control systems including robots, are combined. This enables implementation of electronic devices applicable to automation and the like.

The methods for manufacturing the circuit modules according to the above embodiments can be applied as structure aligning methods. Specifically, the methods for manufacturing circuit module 200 illustrated in FIG. 10 and FIG. 11 can each be viewed as a method for aligning, on an inclined surface, structure A including metal A and structure B including metal B. That is, it is a structure aligning method including, at least: an adhesive application process of applying, to both metal A and metal B, an adhesive material that is meltable or molten; an adhesive contact process of bringing the adhesive material applied to metal A into contact with the adhesive material applied to metal B; a heating process of causing the adhesive material applied to metal A and the adhesive material applied to metal B to coalesce in a molten state; and a cooling process of cooling and solidifying the adhesive materials that are molten. Note that, at this time, a surface of metal A and a surface of metal B are arranged to be parallel to each other.

By employing a method including such processes, a natural phenomenon occurs in which the molten adhesive material tends to reduce its volume as much as possible, thereby enabling utilization of the force that acts to draw metal A and metal B, to which the adhesive material has been applied, closer to each other. It is therefore possible to implement a structure aligning method suitable for aligning structures that include metal such as electrodes.

Note that, according to this technique, it is also possible to provide a structure aligning method in which one of structure A or structure B moves along the inclined surface in a direction against gravity upon alignment.

In this case, the meltable adhesive material may be solder, and one of structure A or structure B has a weight of, for example, 0.005 g or greater and less than 0.1 g, particularly 0.01 g or greater and less than 0.05 g. If structure A and structure B are lighter than this range, the size reduction makes electrode formation difficult, whereas if structure A and structure B are heavier than this range, it becomes difficult for the structures to move under the force generated by molten solder tending to coalesce. The metal is a metal structure containing copper, for example.

Further, the area ratio between metal A and metal B to which the adhesive material is applied is preferably set such that the area of the smaller one relative the area of the larger one is not less than 50%, and the patterns of the two may be similar in shape. This makes it possible to reduce misalignment (deviation) in front-back and left-right directions.

The present invention also includes: other forms obtained through various modifications of the above embodiments conceived by a person skilled in the art; and forms implemented by freely combining the constituent elements and the functions in the above embodiments within a scope not departing from the essence of the present invention. The present invention also includes forms obtained by freely combining one or more constituent elements recited in each of the plurality of claims of the present application as originally filed. Further, when a dependent claim included in the claims of the present application as originally filed is a multiple dependent claim or a nested multiple dependent claim dependent on any combination of claims (for example, dependent on all the preceding claims), the present invention also includes all forms that can be obtained by combinations of all the claims included in such a multiple dependent claim or a nested multiple dependent claim.

### [Reference Signs List]

1, 1A, 1B, 1C, 1D, 1E, 1E', 1F, 1G, 1H, 1H', 1I, 1I', 1J, 1K, 1L, 1M, 1M', 1N, 1N', 1P, 1P' support
1a first mounting surface
1b second mounting surface
2, 2X electronic component
2aS first electrode edge
2bS second electrode edge
3, 5 solder
4, 4A circuit board
11 first electrode
11S first electrode edge
12 second electrode
12S second electrode edge
13 insulator
17 resin member
20 suction portion
30 auxiliary portion
40 receiving portion
100, 100A, 100B, 100C, 100D, 100E, 100E', 100F, 100G, 100H, 100H', 100K, 100M, 100N, 100P, 100P', 100X inclined mounting module
200, 201, 202, 203, 204, 205 circuit module
300, 300X electronic device

## Claims

1. A support to be mounted on a board while supporting an electronic component, the support comprising, at least:
one or more first mounting surfaces on which a mounting surface of the electronic component is to be mounted;
a second mounting surface via which the support is to be mounted on the board;
a first electrode exposed on both the one or more first mounting surfaces and the second mounting surface; and
a second electrode exposed on both the one or more first mounting surfaces and the second mounting surface, wherein
each of the one or more first mounting surfaces is an inclined surface that is inclined relative to the second mounting surface,
the first electrode and the second electrode are thermal conductors that conduct heat from the one or more first mounting surfaces to the second mounting surface,
a first electrode of the electronic component is connected to the first electrode of the support via solder,
a second electrode of the electronic component is connected to the second electrode of the support via solder,
the first electrode of the support exposed on the one or more first mounting surfaces includes a first electrode edge located on a lower side of the inclined surface, and the second electrode of the support exposed on the one or more first mounting surfaces includes a second electrode edge located on the lower side of the inclined surface, and
the first electrode edge and the second electrode edge serve as alignment references for aligning the electronic component when the electronic component is mounted on the support using solder, and are spaced apart from the second mounting surface in a direction orthogonal to the second mounting surface.

2. The support according to claim 1, wherein
the first electrode and the second electrode of the support are made of a metal material having a thermal conductivity of at least 200 W/m·K at room temperature.

3. The support according to claim 1, wherein
the first electrode and the second electrode of the support are made of a metal material containing at least 30 wt% copper.

4. The support according to claim 2 or 3, comprising:
an insulator located between the first electrode and the second electrode of the support, wherein
the insulator is exposed on both the one or more first mounting surfaces and the second mounting surface.

5. The support according to claim 4, wherein
a volume fraction of the metal material in the support is at least 30%.

6. The support according to claim 2 or 3, wherein
the first electrode and the second electrode of the support are bent metal plates.

7. The support according to claim 6, wherein
the first electrode and the second electrode of the support are part of an insert-molded article in which the first electrode and the second electrode of the support are at least partially embedded in a resin member.

8. The support according to any one of claims 1 to 3, comprising:
an auxiliary portion located further on the lower side of the inclined surface than the first electrode edge and the second electrode edge, wherein
the auxiliary portion is exposed on the one or more first mounting surfaces, and
a surface of the auxiliary portion is flush with a surface of the first electrode of the support and a surface of the second electrode of the support.

9. The support according to any one of claims 1 to 3, further comprising:
a receiving portion that receives a surface of the electronic component different from the mounting surface of the electronic component, wherein
the receiving portion protrudes from an end portion of the support on the lower side of the inclined surface, and
a shortest distance between the receiving portion and one of the first electrode or the second electrode of the support is less than one-third of a maximum length of the one or more first mounting surfaces in an inclination direction of the one or more first mounting surfaces inclined relative to the second mounting surface.

10. The support according to any one of claims 1 to 3, wherein
on the one or more first mounting surfaces, each of the first electrode and the second electrode of the support extends in an inclination direction of the one or more first mounting surfaces.

11. The support according to any one of claims 1 to 3, comprising:
a suction portion to which a suction nozzle is to be attached by suction when the support is mounted on the board, wherein
the suction portion is a plane that is located on a back side of the second mounting surface and is parallel to the second mounting surface.

12. The support according to any one of claims 1 to 3, wherein
a maximum width of an upper half of each of the one or more first mounting surfaces is equal to a maximum width of a lower half of each of the one or more first mounting surfaces.

13. The support according to any one of claims 1 to 3, wherein
the first electrode edge and the second electrode edge are part of an edge of the support.

14. An inclined mounting module comprising:
the support according to claim 1; and
an electronic component mounted on the one or more first mounting surfaces of the support via solder.

15. The inclined mounting module according to claim 14, wherein
the first electrode of the electronic component includes a first electrode edge on the lower side of the inclined surface, and the first electrode edge of the first electrode of the electronic component is located at the first electrode edge of the first electrode of the support, and
the second electrode of the electronic component includes a second electrode edge on the lower side of the inclined surface, and the second electrode edge of the second electrode of the electronic component is located at the second electrode edge of the second electrode of the support.

16. The inclined mounting module according to claim 14, wherein
the electronic component is a solid-state light-emitting element or a detection element.

17. The inclined mounting module according to claim 16, wherein
a light output surface of the solid-state light-emitting element or a detection surface of the detection element faces a same direction as a direction perpendicular to the one or more first mounting surfaces.

18. A circuit module comprising:
the inclined mounting module according to claim 14; and
a circuit board on which the inclined mounting module is mounted, wherein
the inclined mounting module is mounted on the circuit board via the second mounting surface of the support.

19. An electronic device comprising:
at least one of the inclined mounting module according to claim 14 or the circuit module according to claim 18.

20. A method for manufacturing the circuit module according to claim 18, the method comprising:
a first placing process of placing an electronic component on the one or more first mounting surfaces of the support via first solder;
a second placing process of placing the support on an electrode of the circuit board via second solder; and
a mounting process of mounting the electronic component on the support using the first solder and mounting the support on the circuit board using the second solder, wherein
the mounting process is performed after the first placing process and the second placing process.

21. A method for manufacturing the circuit module according to claim 18, the method comprising:
a first mounting process of mounting an electronic component on the one or more first mounting surfaces of the support via solder;
an inclining process of inclining the support on which the electronic component has been mounted, the inclining process being performed after the first mounting process; and
a second mounting process of mounting, on an electrode of the circuit board, via solder, the support on which the electronic component has been mounted, the support being mounted via the second mounting surface, the second mounting process being performed after the inclining process, wherein
a first mounting direction in which the electronic component is mounted on the support in the first mounting process and a second mounting direction in which the support is mounted on the electrode of the circuit board in the second mounting process are a same direction.
